(19) Europäisches Patentamt
European Patent Office
Office européen des brevets

(11) **EP 3 276 837 A1**

(12) **EUROPEAN PATENT APPLICATION**
published in accordance with Art. 153(4) EPC

(43) Date of publication:
**31.01.2018 Bulletin 2018/05**

(51) Int Cl.:
***H03M 13/29*** *(2006.01)* ***H04L 1/00*** *(2006.01)*

(21) Application number: **15891450.7**

(86) International application number:
**PCT/CN2015/078544**

(22) Date of filing: **08.05.2015**

(87) International publication number:
**WO 2016/179743 (17.11.2016 Gazette 2016/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Huawei Technologies Co. Ltd.**
**Shenzhen, Guangdong 518129 (CN)**

(72) Inventors:
• **WU, Qiang**
**Shenzhen**
**Guangdong 518129 (CN)**

• **LI, Chao**
**Shenzhen**
**Guangdong 518129 (CN)**
• **ZHOU, Yongxing**
**Shenzhen**
**Guangdong 518129 (CN)**

(74) Representative: **Maiwald Patentanwalts GmbH**
**Engineering**
**Elisenhof**
**Elisenstrasse 3**
**80335 München (DE)**

(54) **ENCODING APPARATUS AND METHOD**

(57) This application discloses a coding method and a communications device. The coding method includes: determining, by a communications device, a second transport block, where the second transport block includes a first transport block and check information corresponding to the first transport block; determining, by the communications device according to scheduling information of the second transport block, a scheme for performing outer-code coding on the second transport block; determining, by the communications device, a third transport block, where when the scheduling information meets a preset condition, the third transport block is a transport block obtained by performing outer-code coding on the second transport block, or when the scheduling information does not meet a preset condition, the third transport block is specifically the second transport block; and performing, by the communications device, inner-code coding on the third transport block according to a predefined rule. According to the foregoing solution, a transmission resource can be effectively used, transmission resource utilization can be improved, an error floor of inner-code coding can be lowered, and data transmission reliability can be increased.

| |
|---|
| A communications device determines a second transport block, where the second transport block includes a first transport block and check information corresponding to the first transport block — S101 |
| The communications device determines, according to scheduling information of the second transport block, a scheme for performing outer-code coding on the second transport block — S102 |
| The communications device determines a third transport block, where when the scheduling information meets a preset condition, the third transport block is a transport block obtained by performing outer-code coding on the second transport block, or when the scheduling information does not meet a preset condition, the third transport block is specifically the second transport block — S103 |
| The communications device performs inner-code coding on the third transport block according to a predefined rule — S104 |

FIG. 1

**Description**

**TECHNICAL FIELD**

This application relates to the communications network field, and in particular, to a coding apparatus and method.

**BACKGROUND**

Data coding is usually implemented by cascading an outer code and an inner code. That is, data is first input into an outer-code coder for outer-code coding. Data obtained by performing the outer-code coding is input into an inner-code coder for inner-code coding. Data obtained by performing the inner-code coding is transmitted by using a transmission resource.

In this case, a Reed-Solomon code (Reed-Solomon Code, RS code) is usually used as an outer code, and a Turbo code is usually used as an inner code.

In such a cascaded coding method, a same RS outer-code coding scheme is usually used for outer-code coding of input data. The RS outer-code coding scheme is represented as (n, n-2t, t), where n is a quantity of symbols after coding, n-2t is a quantity of symbols before coding, and t is an error correction capability.

Because one symbol corresponds to eight bits, it can be learnt from the foregoing outer-code coding scheme that a quantity of bits of data that is input into an RS outer-code coder each time is constant, and that a quantity of bits of data that is output after outer-code coding is also constant.

However, in a Long Term Evolution (Long Term Evolution, LTE) system, when cascaded coding is performed on a transport block by using the foregoing coding scheme, a quantity of bits in each transport block is not constant. Therefore, when a quantity of bits in a transport block is less than (n-2t)*8, invalid data needs to be added to the transport block to increase the quantity of bits to (n-2t)*8, so that outer-code coding can be performed on the transport block. However, the added invalid data increases an error floor of inner-code coding, and reduces data reliability. In addition, during transmission of data that is obtained by performing cascaded coding, the added invalid data occupies an excessively great quantity of transmission resources. When a quantity of bits in a transport block is greater than (n-2t)*8, outer-code coding cannot be performed on a part of data. This may cause a data loss.

**SUMMARY**

This application mainly provides a coding apparatus and method, so as to improve transmission resource utilization, lower an error floor of inner-code coding, and increase data transmission reliability.

To resolve the foregoing problem, according to a first aspect of this application, a coding method is provided, where the method includes: determining, by a communications device, a second transport block, where the second transport block includes a first transport block and check information corresponding to the first transport block; determining, by the communications device according to scheduling information of the second transport block, a scheme for performing outer-code coding on the second transport block; determining, by the communications device, a third transport block, where when the scheduling information meets a preset condition, the third transport block is a transport block obtained by performing outer-code coding on the second transport block, or when the scheduling information does not meet a preset condition, the third transport block is specifically the second transport block; and performing, by the communications device, inner-code coding on the third transport block according to a predefined rule.

With reference to the first aspect, in a first possible implementation of the first aspect of this application, the scheduling information includes a quantity of bits in the second transport block; and the determining, by the communications device according to scheduling information of the second transport block, a scheme for performing outer-code coding on the second transport block includes: when the quantity of bits in the second transport block is greater than a first threshold, performing, by the communications device, first outer-code coding on the second transport block; or when the quantity of bits in the second transport block is not greater than a first threshold, performing, by the communications device, second outer-code coding on the second transport block, or not performing outer-code coding.

With reference to the first aspect, in a second possible implementation of the first aspect of this application, the scheduling information includes a quantity of bits in the second transport block and a modulation scheme of the second transport block; and the determining, by the communications device according to scheduling information of the second transport block, a scheme for performing outer-code coding on the second transport block includes: determining, by the communications device, a second threshold according to the modulation scheme of the second transport block; and when the quantity of bits in the second transport block is greater than the second threshold, determining, by the communications device, to perform third outer-code coding on the second transport block; or when the quantity of bits in the second transport block is not greater than the second threshold, determining, by the communications device, to perform fourth outer-code coding on the second transport block, or not to perform outer-code coding, where the modulation scheme of the second transport block is specifically one or a combination of at least two of a first modulation scheme, a second modulation scheme, or a third modulation scheme, a modulation order of the first modulation scheme is higher than a modulation order of the second modulation scheme, and a second threshold corresponding to the first modulation scheme is greater than a second threshold corresponding to the second modulation scheme.

With reference to the first aspect, or the first or the second possible implementation of the first aspect, in a third possible implementation of the first aspect of this application, the scheduling information includes coding efficiency of inner-code coding; and the determining, by the communications device according to scheduling information of the second transport block, a scheme for performing outer-code coding on the second transport block includes: when the coding efficiency of inner-code coding is first coding efficiency, determining, by the communications device, to perform fifth outer-code coding on the second transport block; or when the coding efficiency of inner-code coding is second coding efficiency, determining, by the communications device, to perform sixth outer-code coding on the second transport block, where the first coding efficiency is higher than the second coding efficiency, and coding efficiency of the fifth outer-code coding is lower than coding efficiency of the sixth outer-code coding.

With reference to the first aspect, in a fourth possible implementation of the first aspect of this application, an outer code includes one or a combination of a Reed-Solomon code (Reed-Solomon Code, RS code) or a Reed-Muller code (Reed-Muller Code, RM), and the outer code includes at least one outer-code coding scheme.

To resolve the foregoing problem, according to a second aspect of this application, a communications device is provided, where the communications device includes a first determining module, an outer-code coding module, a second determining module, and an inner-code coding module; the first determining module is configured to determine a second transport block, where the second transport block includes a first transport block and check information corresponding to the first transport block; the outer-code coding module is configured to determine, according to scheduling information of the second transport block determined by the first determining module, a scheme for performing outer-code coding on the second transport block, and perform outer-code coding on the second transport block by using the determined outer-code coding scheme; the second determining module is configured to determine a third transport block according to the scheduling information of the second transport block, where when the scheduling information meets a preset condition, the third transport block is a transport block obtained by performing outer-code coding on the second transport block, or when the scheduling information does not meet a preset condition, the third transport block is specifically the second transport block; and the inner-code coding module is configured to perform, according to a predefined rule, inner-code coding on the third transport block determined by the second determining module.

With reference to the second aspect, in a first possible implementation of the second aspect of this application, the scheduling information includes a quantity of bits in the second transport block; and the outer-code coding module is specifically configured to: when the quantity of bits in the second transport block is greater than a first threshold, perform first outer-code coding on the second transport block; or when the quantity of bits in the second transport block is not greater than a first threshold, perform second outer-code coding on the second transport block, or not perform outer-code coding.

With reference to the second aspect, in a second possible implementation of the second aspect of this application, the scheduling information includes a quantity of bits in the second transport block and a modulation scheme of the second transport block; and the outer-code coding module is specifically configured to: determine a second threshold according to the modulation scheme of the second transport block; and when the quantity of bits in the second transport block is greater than the second threshold, determine to perform third outer-code coding on the second transport block; or when the quantity of bits in the second transport block is not greater than the second threshold, determine to perform fourth outer-code coding on the second transport block, or not to perform outer-code coding, where the modulation scheme of the second transport block is specifically one or a combination of at least two of a first modulation scheme, a second modulation scheme, or a third modulation scheme, a modulation order of the first modulation scheme is higher than a modulation order of the second modulation scheme, and a second threshold corresponding to the first modulation scheme is greater than a second threshold corresponding to the second modulation scheme.

With reference to the second aspect, or the first or the second possible implementation of the second aspect, in a third possible implementation of the second aspect of this application, the scheduling information includes coding efficiency of inner-code coding; and the outer-code coding module is specifically configured to: when the coding efficiency of inner-code coding is first coding efficiency, determine to perform fifth outer-code coding on the second transport block; or when the coding efficiency of inner-code coding is second coding efficiency, determine to perform sixth outer-code coding on the second transport block, where the first coding efficiency is higher than the second coding efficiency, and coding efficiency of the fifth outer-code coding is lower than coding efficiency of the sixth outer-code coding.

With reference to the second aspect, in a fourth possible implementation of the second aspect of this application, an outer code includes one or a combination of a Reed-Solomon code (Reed-Solomon Code, RS code) or a Reed-Muller code (Reed-Muller Code, RM), and the outer code includes at least one outer-code coding scheme.

To resolve the foregoing problem, according to a third aspect of this application, a communications device is provided, where the communications device includes a memory and a processor; the memory is configured to store data; the processor is configured to determine a second transport block, where the second transport block includes a first transport block and check information corresponding to the first transport block; the processor is further configured to determine, according to scheduling information of the second transport block, a scheme for performing outer-code coding on the second transport block, and perform outer-code coding on the second transport block by using the determined outer-code coding scheme; the processor is further configured to determine a third transport block according to the scheduling information of the second transport block, where when the scheduling information meets a preset condition, the third transport block is a transport block obtained by performing outer-code coding on the second transport block, or when the scheduling information does not meet a preset condition, the third transport block is specifically the second transport block; and the processor is further configured to perform inner-code coding on the third transport block according to a predefined rule.

With reference to the third aspect, in a first possible implementation of the third aspect of this application, the scheduling information includes a quantity of bits in the second transport block; and the processor is specifically configured to: when the quantity of bits in the second transport block is greater than a first threshold, perform first outer-code coding on the second transport block; or when the quantity of bits in the second transport block is not greater than a first threshold, perform second outer-code coding on the second transport block, or not perform outer-code coding.

With reference to the third aspect, in a second possible implementation of the third aspect of this application, the scheduling information includes a quantity of bits in the second transport block and a modulation scheme of the second transport block; and the processor is specifically configured to: determine a second threshold according to the modulation scheme of the second transport block; and when the quantity of bits in the second transport block is greater than the second threshold, determine to perform third outer-code coding on the second transport block; or when the quantity of bits in the second transport block is not greater than the second threshold, determine to perform fourth outer-code coding on the second transport block, or not to perform outer-code coding, where the modulation scheme of the second transport block is specifically one or a combination of at least two of a first modulation scheme, a second modulation scheme, or a third modulation scheme, a modulation order of the first modulation scheme is higher than a modulation order of the second modulation scheme, and a second threshold corresponding to the first modulation scheme is greater than a second threshold corresponding to the second modulation scheme.

With reference to the third aspect, or the first or the second possible implementation of the third aspect, in a third possible implementation of the third aspect of this application, the scheduling information includes coding efficiency of inner-code coding; and the processor is specifically configured to: when the coding efficiency of inner-code coding is first coding efficiency, determine to perform fifth outer-code coding on the second transport block; or when the coding efficiency of inner-code coding is second coding efficiency, determine to perform sixth outer-code coding on the second transport block, where the first coding efficiency is higher than the second coding efficiency, and coding efficiency of the fifth outer-code coding is lower than coding efficiency of the sixth outer-code coding.

With reference to the third aspect, in a fourth possible implementation of the third aspect of this application, an outer code includes one or a combination of a Reed-Solomon code (Reed-Solomon Code, RS code) or a Reed-Muller code (Reed-Muller Code, RM), and the outer code includes at least one outer-code coding scheme.

In the foregoing solutions, the communications device determines the second transport block, and determines, according to the scheduling information of the second transport block, the scheme for performing outer-code coding on the second transport block, so as to determine whether to perform outer-code coding on the second transport block. After determining the third transport block, the communications device performs inner-code coding on the third transport block according to the predefined rule. In this way, a transmission resource can be effectively used, transmission resource utilization can be improved, an error floor of inner-code coding can be lowered, and data transmission reliability can be increased.

## BRIEF DESCRIPTION OF DRAWINGS

FIG. 1 is a flowchart of an embodiment of a coding method in this application;
FIG. 2 is a flowchart of another embodiment of a coding method in this application;
FIG. 3 is a schematic structural diagram of an embodiment of a communications device in this application; and
FIG. 4 is a schematic structural diagram of another embodiment of a communications device in this application.

## DESCRIPTION OF EMBODIMENTS

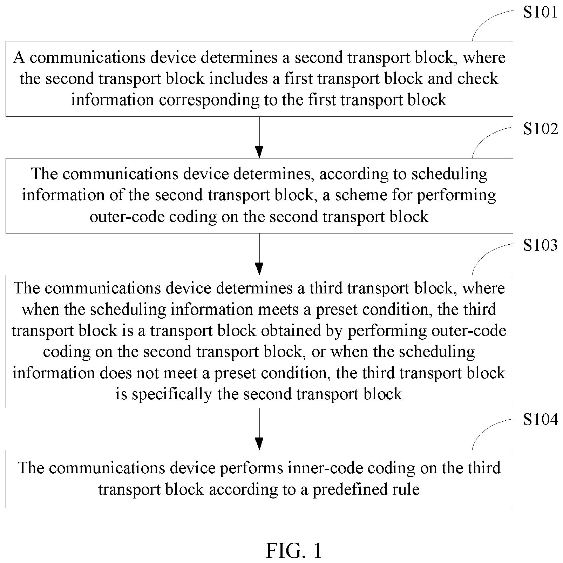

In the following descriptions, for a purpose of illustration rather than limitation, specific details such as a particular system structure, interface, and technology are provided, to facilitate thorough understanding of this application.
Referring to FIG. 1, FIG. 1 is a flowchart of an embodiment of a coding method in this application. This embodiment is executed by a communications device. The communications device may be a base station, or may be a terminal. When the communications device is a base station, a transmit end is the base station, a receive end is a terminal, and a communication channel between the base station and the terminal is a physical downlink shared channel (Physical Downlink Shared Channel, PDSCH). When the communications device is a terminal, a transmit end is the terminal, a receive end is a base station, and a communication channel between the base station and the terminal is a physical uplink shared channel (Physical Uplink Shared Channel, PUSCH). In this embodiment, the PDSCH is used as an example for description (a coding method for the PUSCH is similar to a coding method for the PDSCH). This embodiment includes the following steps.

S101: The communications device determines a second transport block, where the second transport block includes a first transport block and check information corresponding to the first transport block.

In a Long Term Evolution (Long Term Evolution, LTE) system, the communications device checks the first transport block (Transport Block, TB), to obtain the second transport block.

The first transport block is to-be-transmitted original data, and the second transport block includes the first transport block and the check information corresponding to the first transport block. The first transport block and the second transport block are in units of bits (bit). The check information may be cyclic redundancy check (Cyclic Redundancy Check, CRC) information, may be parity check information, may be Hamming check information, or the like. This is not limited herein.

In this embodiment, the check information is CRC check information. The communications device performs cyclic redundancy check on the first transport block, that is, adds 24 CRC check bits to the end of the first transport block.

In another embodiment, parity check, Hamming check, or the like may be performed on the first transport block. For specific check manners of parity check and Hamming check, refer to related implementation methods. Details are not described herein.

S102: The communications device determines, according to scheduling information of the second transport block, a scheme for performing outer-code coding on the second transport block.

The communications device obtains the scheduling information included in the second transport block, and determines, according to the scheduling information of the second transport block, the scheme for performing outer-code coding on the second transport block, or determines, according to the scheduling information of the second transport block, not to perform outer-code coding on the second transport block.

The scheduling information is used to indicate information about that the base station schedules a resource block (Resource Block, RB) from an available transmission resource. The RB is used for transmitting data included in the second transport block. In a frequency domain, the base station performs scheduling by using an RB as a granularity. In the LTE system, a minimum unit of scheduling by the base station is a resource block pair (Physical Resource Block pair, PRB).

The scheduling information included in the second transport block may at least be one of the following or a combination of at least two of the following: a quantity of bits in the second transport block, a modulation scheme of the second transport block, or coding efficiency of inner-code coding of the second transport block. A Turbo code may be used for inner-code coding. However, this is not limited. Another inner code may be used.

The quantity of bits in the second transport block is used to indicate a quantity of bits occupied by the data included in the second transport block. The communications device may determine, according to the quantity of bits in the second transport block and a maximum quantity of bits that are allowed to be input in an outer-code coding scheme, the scheme for performing outer-code coding on the second transport block, or determine, according to the scheduling information of the second transport block, not to perform outer-code coding on the second transport block.

The modulation scheme of the second transport block is used to indicate a modulation scheme used for the data included in the second transport block. The communications device may determine, according to the modulation scheme of the second transport block, the scheme for performing outer-code coding on the second transport block, or determine, according to the scheduling information of the second transport block, not to perform outer-code coding on the second transport block.

The modulation scheme may include quadrature phase shift keying (Quadrature Phase Shift Keying, QPSK), quadrature amplitude modulation (Quadrature Amplitude Modulation, 16QAM), and quadrature amplitude modulation (Quadrature Amplitude Modulation, 64QAM). A higher order of the modulation scheme indicates a higher error floor, a poorer error correction capability, and lower data transmission reliability. When the modulation scheme of the second transport block has a relatively high order, outer-code coding may be performed on the second transport block by using an outer-code coding scheme with relatively low coding efficiency. When the modulation scheme of the second transport block has a relatively low order and an error floor can satisfy a requirement, outer-code coding may not be performed on the second transport block.

The coding efficiency of inner-code coding of the second transport block is used to indicate a ratio of a quantity of input bits in inner-code coding of the second transport block to a quantity of output bits in inner-code coding of the second transport block. Higher coding efficiency of inner-code coding of the second transport block indicates a higher error floor of inner-code coding of the second transport block, a poorer error correction capability, and lower data transmission reliability. When the coding efficiency of inner-code coding of the second transport block is relatively high, outer-code coding may be performed on the second transport block by using an outer-code coding scheme with relatively low coding efficiency. When the coding efficiency of inner-code coding of the second transport block is relatively low and an error floor can satisfy a requirement, outer-code coding may not be performed on the second transport block.

An outer code includes one or a combination of a Reed-Solomon code (Reed-Solomon Code, RS code) or a Reed-Muller code (Reed-Muller Code, RM), and the outer code includes at least one outer-code coding scheme.

The outer-code coding scheme is preset. When there is only one outer-code coding scheme, the scheme for performing outer-code coding on the second transport block is determined as the only one outer-code coding scheme.

When there are at least two outer-code coding schemes, an outer-code coding scheme that matches the scheduling information is selected from the at least two outer-code coding schemes according to the scheduling information of the second transport block.

In this embodiment, the outer code is an RS code. The RS code is represented as (n, n-2t, t), where n is a quantity of symbols after coding, n-2t is a quantity of symbols before coding, t is an error correction capability, and one symbol corresponds to eight bits. In two RS coding schemes, when any one of n, n-2t, or t in one scheme is different from that in the other scheme, the two RS coding schemes are different. In another embodiment, alternatively, the outer code may be an RM code, a BCH code, or a combination of at least two outer codes. This is not limited herein.

Different outer-code coding schemes have different error correction capabilities. A stronger error correction capability of the outer-code coding scheme of the second transport block indicates a lower error floor of inner-code coding of the second transport block and higher data transmission reliability.

S103: The communications device determines a third transport block, where when the scheduling information meets a preset condition, the third transport block is a transport block obtained by performing outer-code coding on the second transport block, or when the scheduling information does not meet a preset condition, the third transport block is specifically the second transport block.

The communications device determines the third transport block according to the scheduling information of the second transport block. When the scheduling information of the second transport block meets the preset condition, the communications device performs outer-code coding on the second transport block by using the determined outer-code coding scheme, and the third transport block is the transport block obtained by performing outer-code coding on the second transport block.

It can be understood that the second transport block may include one or at least two code blocks when outer-code coding is performed on the second transport block. When the second transport block includes at least two code blocks, the communications device separately performs outer-code coding on each code block by using the determined outer-code coding scheme, and sequentially connects outer-code code blocks that are obtained by performing outer-code coding, to connect all the outer-code code blocks in series, thereby obtaining the third transport block.

When the quantity of bits in the second transport block is less than or equal to a maximum quantity of bits that are allowed to be input in the determined outer-code coding scheme, the communications device does not perform code block division on the second transport block. The second transport block includes one code block, and outer-code coding is performed on the second transport block directly by using the determined outer-code coding scheme. The second transport block obtained by performing outer-code coding is the third transport block.

When the quantity of bits in the second transport block is greater than a maximum quantity of bits that are allowed to be input in the determined outer-code coding scheme, the communications device performs code block division on the second transport block, divides the second transport block into at least two code blocks, then separately performs outer-code coding on each code block by using the determined outer-code coding scheme, and sequentially connects outer-code code blocks that are obtained by performing outer-code coding. In this way, all the outer-code code blocks are connected in series, and the third transport block is obtained.

For example, it is assumed that a quantity of bits in the first transport block is 3752, and a quantity of bits after check (CRC check) is performed on the first transport block is 3752+24=3776. In this case, the quantity of bits in the second transport block is 3776.

When the determined outer-code (RS code) coding scheme is (255, 239, 4), because one symbol corresponds to eight bits, a quantity of bits that are input for one RS code block is 239*8=1912. In addition, because the quantity of bits in the second transport block is 3776, the communications device needs to divide the second transport block into two code blocks, to perform outer-code coding on the second transport block.

Because 1912*2=3824>3776, the communications device needs to add 24 padding bits to the start or the end of each code block before performing outer-code coding on the second transport block, so that a quantity of bits that are input for each code block is 1912. Then, the communications device performs outer-code coding on each code block, and outputs data of 255*8*2=4080 bits. After performing outer-code coding on all the code blocks included in the second transport block, the communications device sequentially connects outer-code code blocks that are obtained by performing outer-code coding, to connect all the outer-code code blocks in series, thereby obtaining the third transport block. When the scheduling information of the second transport block does not meet the preset condition, the communications device does not perform outer-code coding on the second transport block, and the third transport block is specifically the second transport block.

The preset condition is a rule that is preset and that is stored on the communications device. The preset condition may be set according to an error floor of an inner code corresponding to the second transport block, so that an error floor of the second transport block after inner-code coding can satisfy a current data transmission requirement and ensure data transmission reliability.

When the error floor of the inner code corresponding to the second transport block can satisfy the current data transmission requirement, it is determined that the scheduling information of the second transport block does not meet the preset condition, and outer-code coding does not need to be performed on the second transport block. When the error floor of the inner code corresponding to the second transport block cannot satisfy the current data transmission requirement, it is determined that the scheduling information of the second transport block meets the preset condition, and outer-code coding needs to be performed on the second transport block.

The preset requirement may be that the quantity of bits in the transport block included in the scheduling information meets a preset requirement, may be that the modulation scheme of the transport block included in the scheduling information is a preset modulation scheme, or may be that the quantity of bits in the transport block meets a preset requirement and the modulation scheme of the transport block is a preset modulation scheme. However, this is not limited. The preset condition may be another preset condition.

S104: The communications device performs inner-code coding on the third transport block according to a predefined rule.

After the communications device determines the third transport block, the communications device performs inner-code coding on the third transport block according to the predefined rule, so that an error floor of the third transport block after inner-code coding can satisfy a current data transmission requirement and ensure data transmission reliability.

The predefined rule may be an inner-code coding method in the prior art. In this embodiment, a coding scheme in which an inner code is a Turbo code is used as an example for description. However, this is not limited. Alternatively, an inner code may be a convolutional code or another inner code. A Turbo-code coding scheme is specifically as follows:

(1) The communications device determines whether a quantity of bits in the third transport block is greater than 6144, performs, when the quantity of bits in the third transport block is greater than 6144, code block division on the third transport block, and checks each code block that is obtained by performing the division.

The communications device obtains the quantity of bits in the third transport block, and determines whether the quantity of bits in the third transport block is greater than 6144. When the quantity of bits in the third transport block is greater than 6144, the communications device performs code block division on the third transport block, and checks each code block that is obtained by performing the division, so as to meet a requirement of a subsequent channel coding (inner-code coding) scheme.

After code block division is performed, the third transport block is divided into code blocks whose sizes are the same. It is assumed that the third transport block is divided into C code blocks, and the obtained code blocks are denoted as $c_{r0}, c_{r1}, c_{r2}, c_{r3}, ..., c_{r(K, -1)}$, where r is a sequence number of a code block, $0 < r \leq C$, and Kr is a quantity of bits in the $r^{th}$ code block.

In this embodiment, the communications device performs cyclic redundancy check on each code block included in the third transport block, that is, adds 24 CRC check bits to the end of each code block included in the third transport block.

In another embodiment, parity check, Hamming check, or the like may be performed on each code block included in the third transport block. For specific check manners of parity check and Hamming check, refer to related implementation methods. Details are not described herein.

When the quantity of bits in the third transport block is less than or equal to 6144, the communications device performs step (2).

(2) The communications device performs Turbo coding on the third transport block.

The communications device separately performs channel coding on each code block included in the third transport block.

When the quantity of bits in the third transport block is less than or equal to 6144, the third transport block includes one code block, and the communications device performs inner-code coding on the third transport block.

When the quantity of bits in the third transport block is greater than 6144, the third transport block includes at least two code blocks, and the communications device separately performs inner-code coding on each checked code block.

For the $r^{th}$ code block, a code block obtained by performing Turbo coding includes three code streams that are denoted as $d_{r0}^{(i)}, d_{r1}^{(i)}, d_{r2}^{(i)}, d_{r3}^{(i)}, ..., d_{r(D_r-1)}^{(i)}$, where i=0, 1, or 2, Dr is a quantity of bits in the $i^{th}$ code stream of the $r^{th}$ code block, and Dr=Kr+4. Herein, the stream for which i=0 includes an information bit, and the stream for which i=1 or 2 is a redundant bit added in Turbo coding.

A Turbo coding method is the same as a Turbo coding method in the prior art. For specific details, refer to the Turbo coding method in the prior art. Details are not described herein.

(3) The communications device performs rate matching on each Turbo code block.

After performing Turbo coding on each code block in the third transport block, the communications device separately performs sub-block interleaving on three code streams of each code block, to perform rate matching on each code block.

During sub-block interleaving, a matrix of $C_{subblock}^{TC} = 32$ columns and $R_{subblock}^{TC}$ rows is designed, where $R_{subblock}^{TC}$ is a minimum value that satisfies $D_r \leq \left( R_{subblock}^{TC} \times C_{subblock}^{TC} \right)$. A bit in each stream is written into the matrix by row, row-column displacement is performed on the matrix, and then a bit stream is read by column. In this way, an obtained bit stream is $v_0^{(i)}, v_1^{(i)}, v_2^{(i)}, ..., v_{K_\Pi-1}^{(i)}$, where i=0, 1, or 2, and $K_\Pi$ is a quantity of bits in each of three bit streams of one code block obtained by performing sub-block interleaving. A stream for which i=0 includes an information bit. The three bit streams are placed into a cache. For physical uplink shared channel (Physical Uplink Shared Channel, PUSCH) data, a size of a cache is $N_{cb} = K_w = 3K_\Pi$, and bits in the cache are denoted as $w_k, k=0,...,N_{cb}-1$, where $w_k = v_k^{(0)}$, $w_{K_\Pi+2k} = v_k^{(1)}$, $w_{K_\Pi+2k+1} = v_k^{(2)}$, and k = 0,..., $K_\Pi$ -1. Therefore, the data in the cache is arranged as follows:

| $K_\Pi$ bits (including an information bit Kr) | $2K_\Pi$ check bits |
| --- | --- |

A sequence length obtained by performing rate matching on the $r^{th}$ code block is represented as Er, and a redundancy version number is represented as rvidx, where rvidx=0, 1, 2, or 3.

A total quantity of bits that can be used in transmission of one transport block is represented as G. That is, G represents, at a bit level, a resource that can be occupied by one transport block.

It is set that $G' = G/(N_L \cdot Q_m)$. When a used modulation scheme is QPSK, $Q_m$=2. When a used modulation scheme is 16QAM, $Q_m$=4. When a used modulation scheme is 64QAM, $Q_m$=6. When transmission diversity is used, $N_L$ is equal to 2. In another case, $N_L$ is equal to a quantity of layers to which one transport block is mapped.

It is set that $\gamma = G' \bmod C$, where C is a total quantity of code blocks. If $r \leq C-\gamma-1$, $E_r = N_L \cdot Q_m \cdot \lfloor G'/C \rfloor$, where $G'$ is a quantity of symbols transmitted on a scheduled resource block, and r represents the $r^{th}$ code block (code block). Otherwise, $E_r = N_L \cdot Q_m \cdot \lceil G'/C \rceil$, where $E_r$ represents a quantity of bits, in the $r^{th}$ code block, that need to be transmitted.

According to the foregoing allocation manner, $\lfloor G'/C \rfloor$ and $\lceil G'/C \rceil$ represent a quantity of sent symbols in a code block. Quantities of symbols in two different code blocks differ by a maximum of one symbol. A previous code block for which $r \leq C-\gamma-1$ (r is numbered from 0) has one less symbol.

A process of bit selection and puncturing is as follows:

It is set that $k_0 = R_{subblock}^{TC} \cdot \left( 2 \cdot \left\lceil \dfrac{N_{cb}}{8 R_{subblock}^{TC}} \right\rceil \cdot rv_{idx} + 2 \right)$, representing a start location of bit selection. Then, starting from $k_0$, Er bits are sequentially and cyclically selected from $w_k$, and the selected bits are not dummy bits.

A schematic diagram of the process of bit selection and puncturing is as follows:

k0

| Er bits | |
| --- | --- |
| $K_\Pi$ bits (including an information bit Kr) | $2K_\Pi$ check bits |

For a code block r, bits obtained by performing rate matching are $e_{r0}, e_{r1}, e_{r2}, e_{r3}, ..., e_{r(Er-1)}$.

After performing rate matching on all the code blocks, the communications device sequentially connects all the code blocks, to obtain final coded bits. A quantity of the final coded bits is G.

After performing inner-code coding on the third transport block, the communications device modulates G coded bits in one transport block, maps coded data as a modulated symbol, and then puts the modulated symbol onto a corresponding resource (RB) in one subframe for transmission.

In this embodiment, the Turbo coding (channel coding) method, a rate matching method, and a rate are the same as methods in the prior art. For specific details, refer to related descriptions in the prior art. Details are not described herein.

It can be understood that the coding method for the PUSCH is similar to the coding method for the PDSCH. For specific details, refer to the foregoing coding method for the PDSCH. Details are not described herein again. Decoding is a reverse process of coding. Details about a decoding process are not described herein.

In the foregoing solution, the communications device determines the second transport block, and determines, according to the scheduling information of the second transport block, the scheme for performing outer-code coding on the second transport block, so as to determine whether to perform outer-code coding on the second transport block. After determining the third transport block, the communications device performs inner-code coding on the third transport block according to the predefined rule. In this way, a transmission resource can be effectively used, transmission resource utilization can be improved, an error floor of inner-code coding can be lowered, and data transmission reliability can be increased.

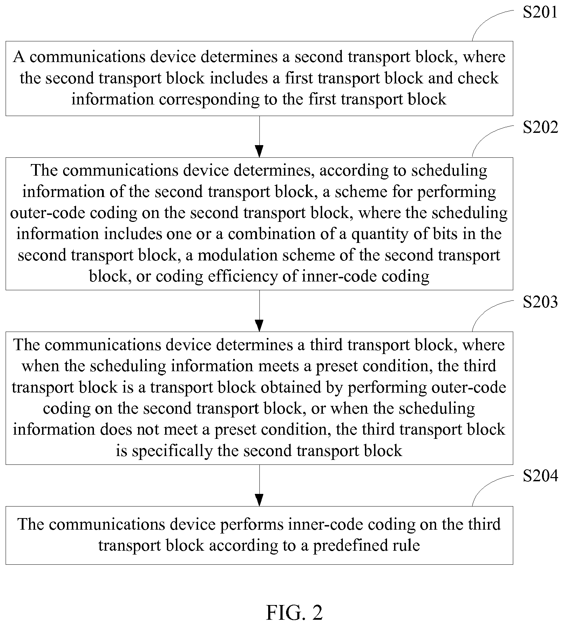

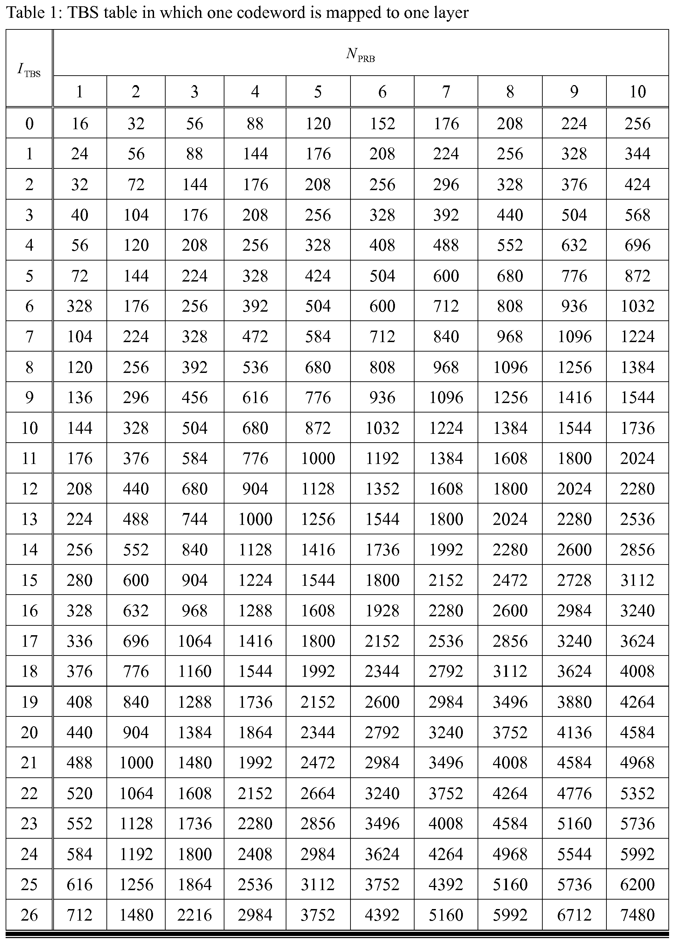

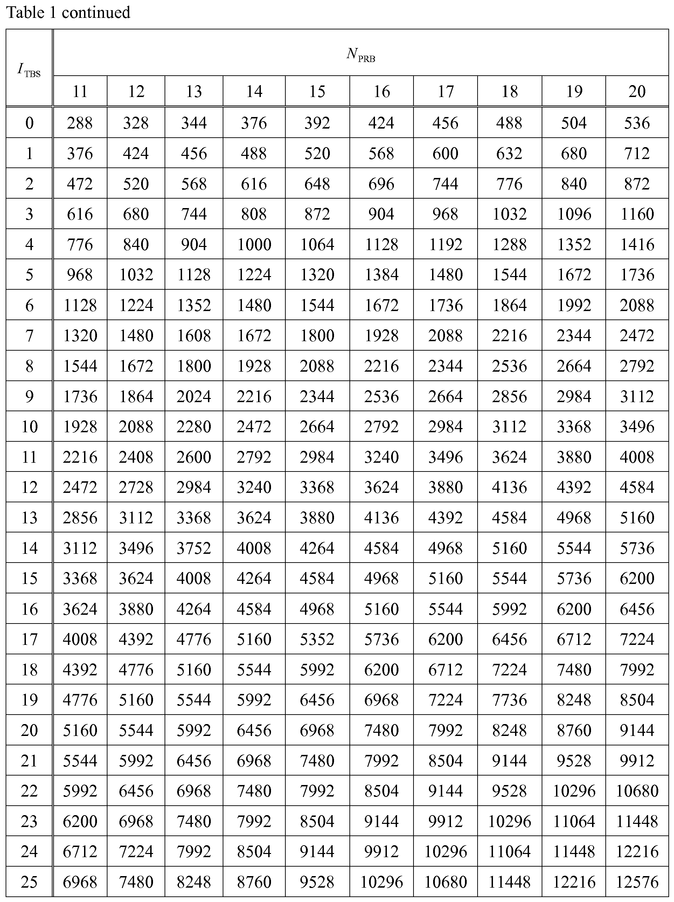

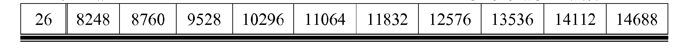

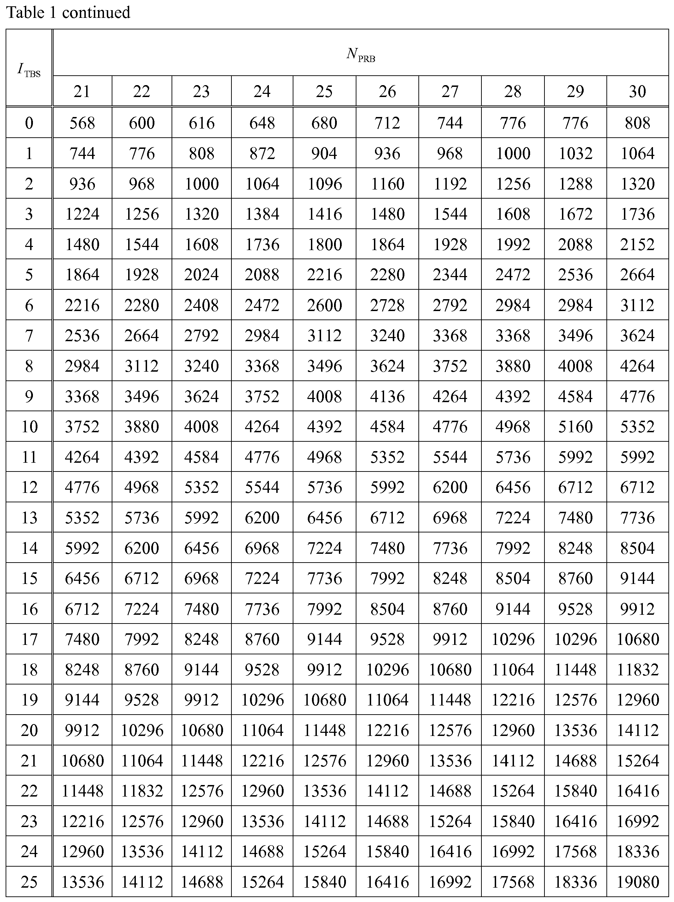

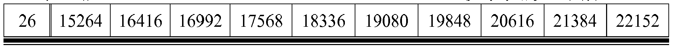

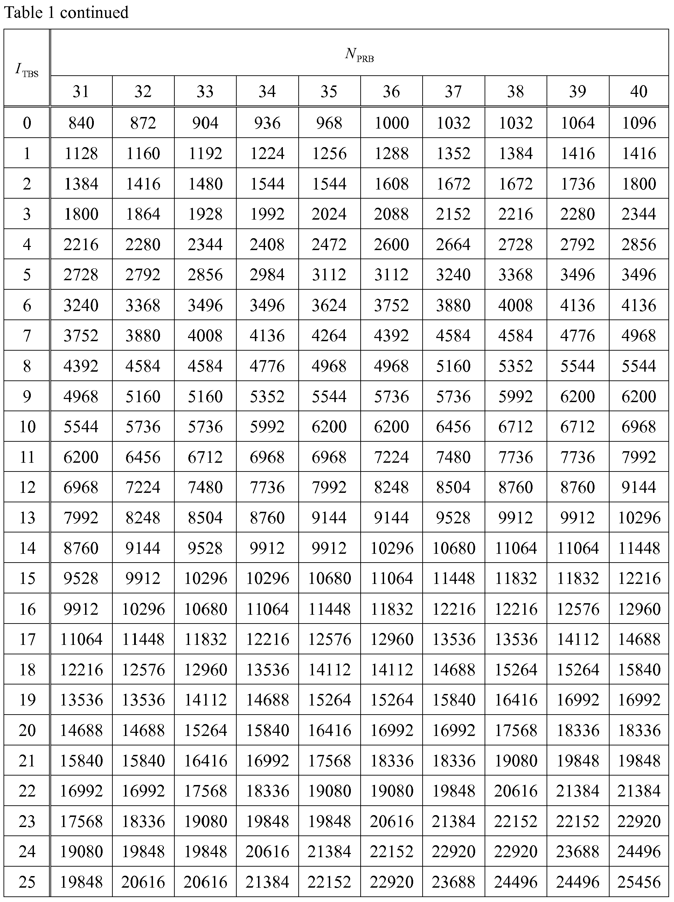

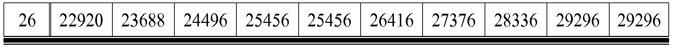

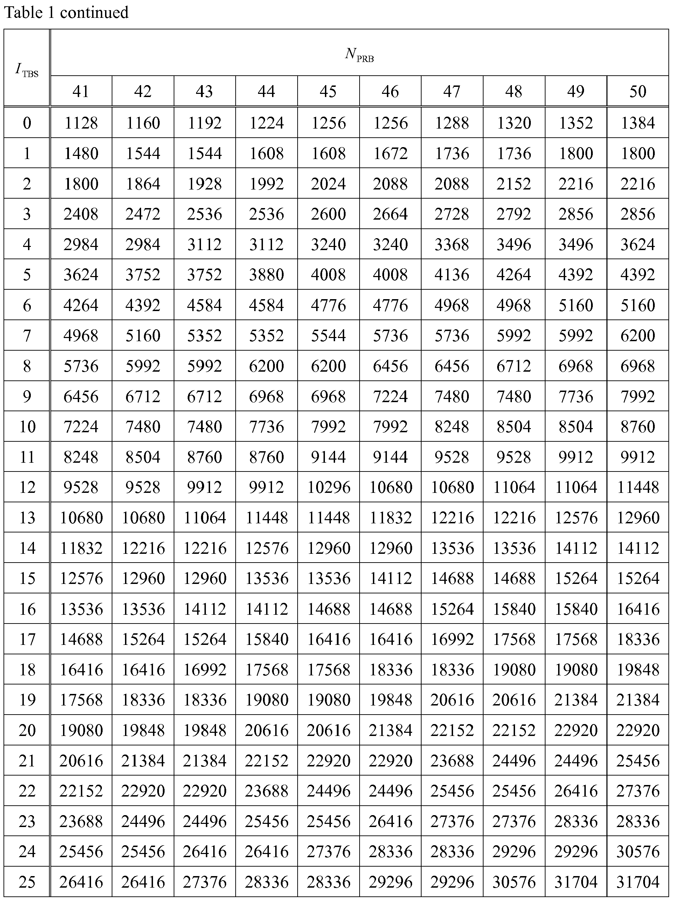

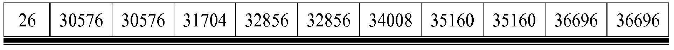

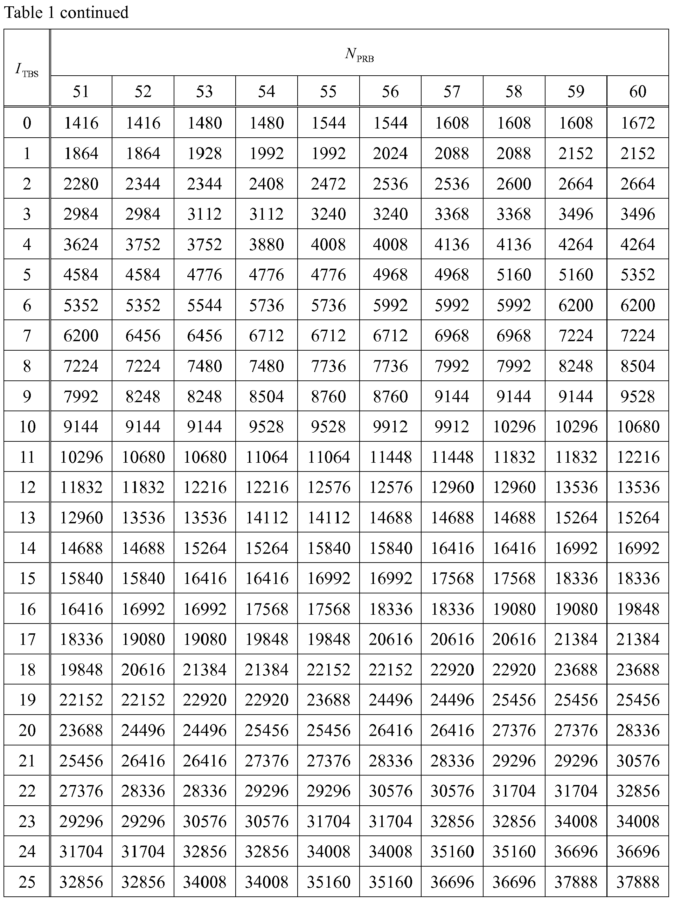

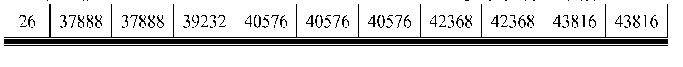

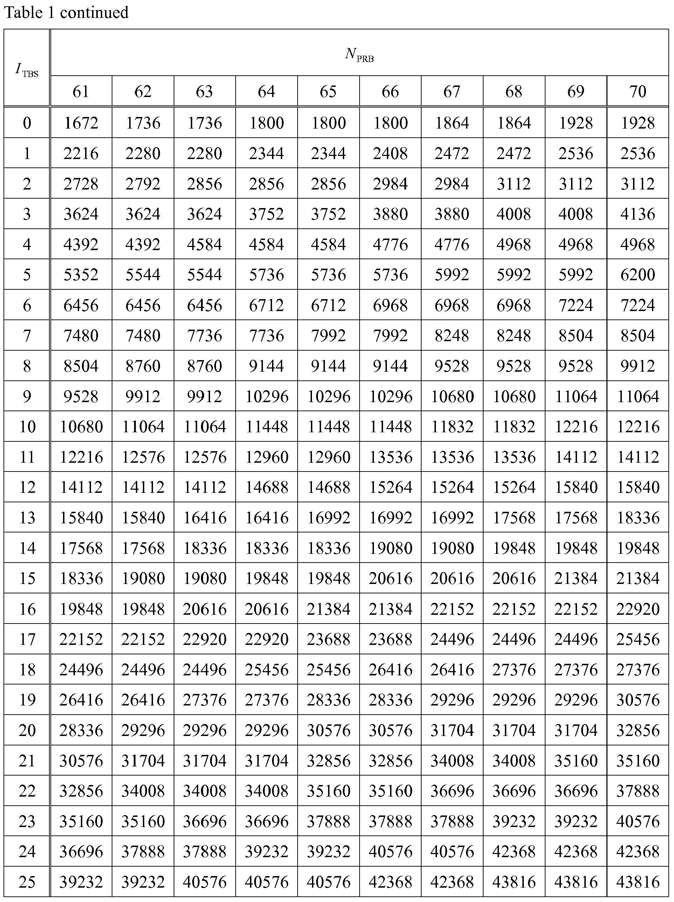

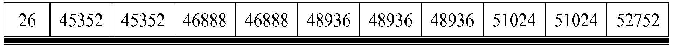

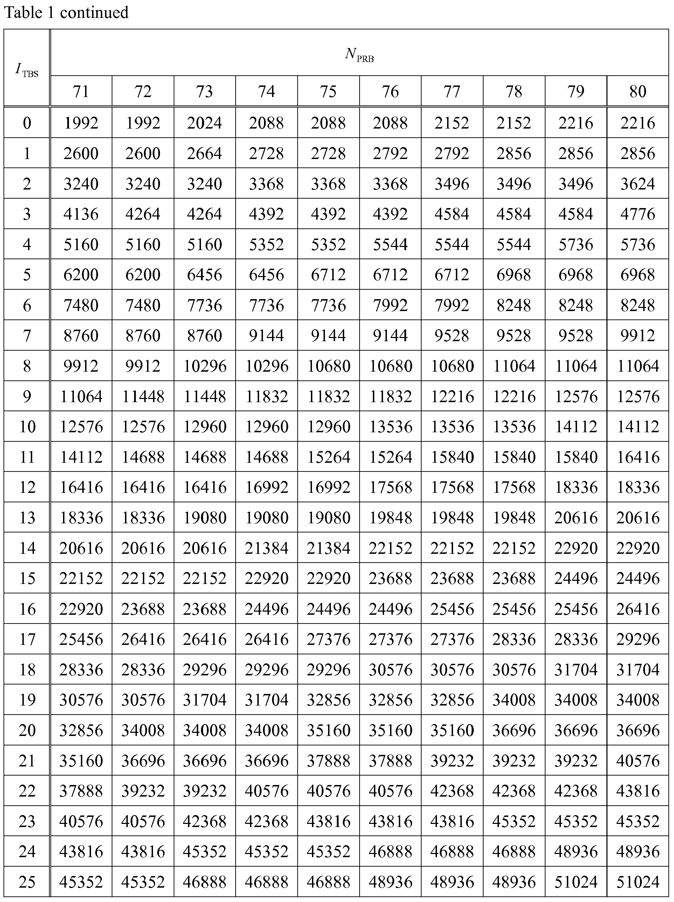

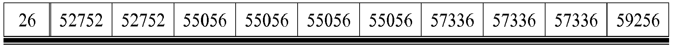

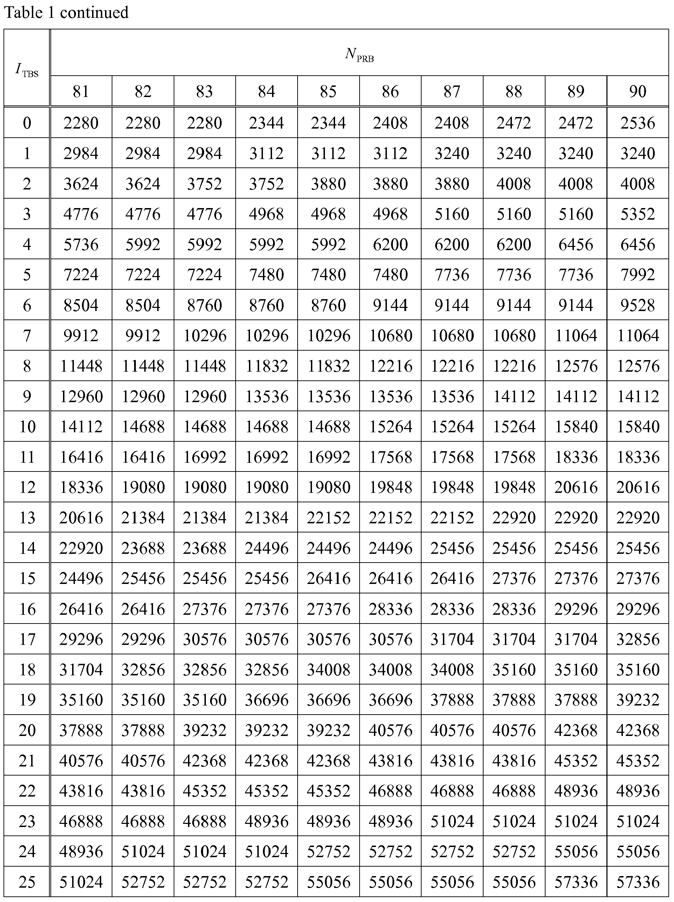

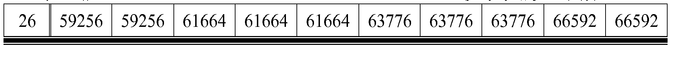

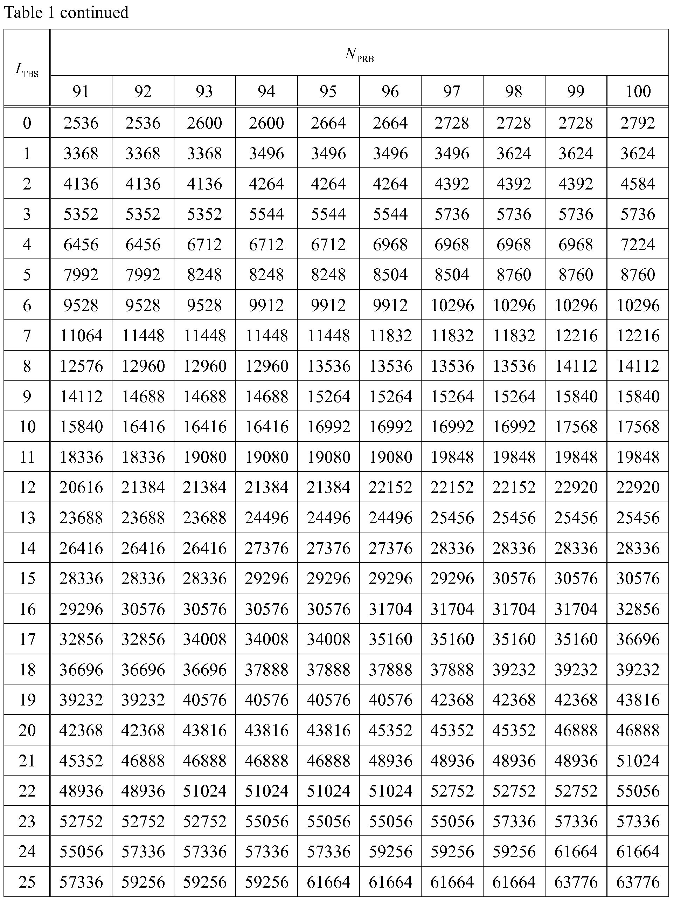

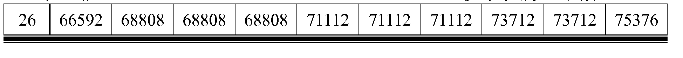

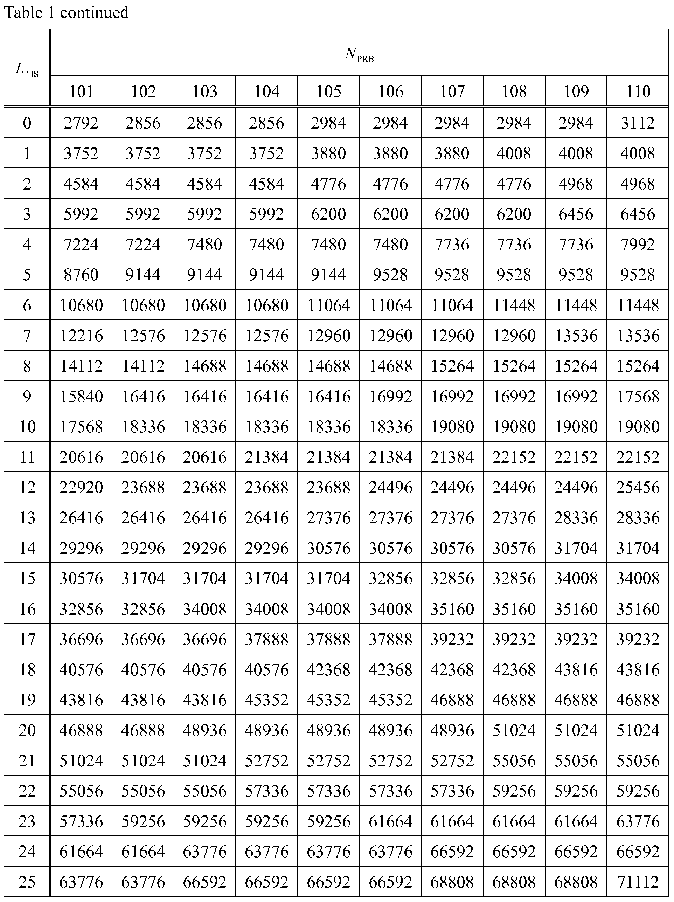

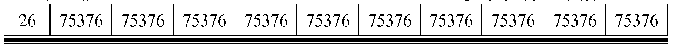

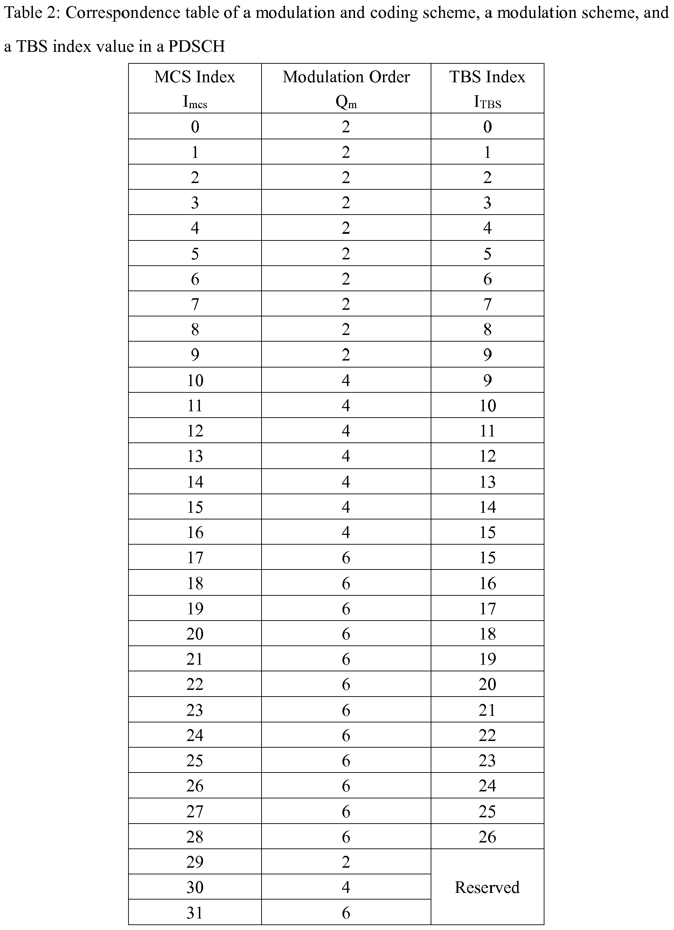

Referring to FIG. 2, FIG. 2 is a flowchart of another embodiment of a coding method in this application. This embodiment is executed by a communications device. The communications device may be a base station, or may be a terminal. When the communications device is a base station, a transmit end is the base station, a receive end is a terminal, and a communication channel between the base station and the terminal is a physical downlink shared channel (Physical Downlink Shared Channel, PDSCH). When the communications device is a terminal, a transmit end is the terminal, a receive end is a base station, and a communication channel between the base station and the terminal is a physical uplink shared channel (Physical Uplink Shared Channel, PUSCH). In this embodiment, the PDSCH is used as an example for description. This embodiment includes the following steps.

S201: The communications device determines a second transport block, where the second transport block includes a first transport block and check information corresponding to the first transport block.

In a Long Term Evolution (Long Term Evolution, LTE) system, the communications device checks the first transport block (Transport Block, TB), to obtain the second transport block.

The first transport block is to-be-transmitted original data, and the second transport block includes the first transport block and the check information corresponding to the first transport block. The first transport block and the second transport block are in units of bits (bit). The check information may be cyclic redundancy check (CyclicRedundancyCheck, CRC) information, may be parity check information, may be Hamming check information, or the like. This is not limited herein.

In this embodiment, the check information is CRC check information. The communications device performs cyclic redundancy check on the first transport block, that is, adds 24 CRC check bits to the end of the first transport block.

In another embodiment, parity check, Hamming check, or the like may be performed on the first transport block. For specific check manners of parity check and Hamming check, refer to related implementation methods. Details are not described herein.

S202: The communications device determines, according to scheduling information of the second transport block, a scheme for performing outer-code coding on the second transport block, where the scheduling information includes a quantity of bits in the second transport block, a modulation scheme of the second transport block, and coding efficiency of inner-code coding.

The communications device obtains the scheduling information included in the second transport block, and determines, according to the scheduling information of the second transport block, the scheme for performing outer-code coding on the second transport block, or determines, according to the scheduling information of the second transport block, not to perform outer-code coding on the second transport block.

The scheduling information includes the quantity of bits in the second transport block, the modulation scheme of the second transport block, and the coding efficiency of inner-code coding. However, this is not limited. The scheduling information may further include other information.

The scheduling information is used to indicate information about that the base station schedules a resource block (Resource Block, RB) from an available transmission resource. The RB is used for transmitting data included in the second transport block. In a frequency domain, the base station performs scheduling by using an RB as a granularity. In the LTE system, a minimum unit of scheduling by the base station is a resource block pair (Physical Resource Block pair, PRB).

An outer code includes one or a combination of a Reed-Solomon code (Reed-Solomon Code, RS code) or a Reed-Muller code (Reed-Muller Code, RM), and the outer code includes at least one outer-code coding scheme.

The outer-code coding scheme is preset. When there is only one outer-code coding scheme, the scheme for performing outer-code coding on the second transport block is determined as the only one outer-code coding scheme. When there are at least two outer-code coding schemes, an outer-code coding scheme that matches the scheduling information is selected from the at least two outer-code coding schemes according to the scheduling information of the second transport block.

In this embodiment, the outer code is an RS code. The RS code is represented as (n, n-2t, t), where n is a quantity of symbols after coding, n-2t is a quantity of symbols before coding, t is an error correction capability, and one symbol corresponds to eight bits. In two RS coding schemes, when any one of n, n-2t, or t in one scheme is different from that in the other scheme, the two RS coding schemes are different. In another embodiment, alternatively, the outer code may be an RM code, a BCH code, or a combination of at least two outer codes. This is not limited herein.

Different outer-code coding schemes have different error correction capabilities. A stronger error correction capability of the outer-code coding scheme of the second transport block indicates a lower error floor of inner-code coding of the second transport block and higher data transmission reliability.

In an implementation, when the scheduling information of the second transport block includes the quantity of bits in the second transport block, the step that the communications device determines, according to the scheduling information of the second transport block, a scheme for performing outer-code coding on the second transport block is specifically as follows:

The communications device determines, according to the quantity of bits in the second transport block, the scheme for performing outer-code coding on the second transport block. When the quantity of bits in the second transport block is greater than a first threshold, the communications device performs first outer-code coding on the second transport block. When the quantity of bits in the second transport block is not greater than a first threshold, the communications device performs second outer-code coding on the second transport block, or does not perform outer-code coding.

For example, referring to Table 1, Table 1 is a TBS table in which one codeword is mapped to one layer. At a transport layer, one TB is considered as one codeword. A TBS table in which one codeword is mapped to one layer is stored on communications devices (a base station and a terminal).

In Table 1, $I_{TBS}$ is an index value of a TBS in scheduling information, $N_{PRB}$ is a quantity of RBs in the scheduling information, and $N_{PRB}$ is used to indicate a quantity of RBs used for transmitting data included in a transport block. A value range of the index value of the TBS is 0 to 26, that is, $I_{TBS}$=0, 1, 2, ...25, 26. A value range of $N_{PRB}$ is 1 to 110, that is, $N_{PRB}$=0, 1, 2, 3, ...109, 110. One $I_{TBS}$ and $N_{PRB}$ correspond to one TBS value. The TBS is in units of bits, and a range of the TBS is 16 to 75376. For example, when $I_{TBS}$=10 and $N_{PRB}$=1 in the scheduling information, a corresponding TBS value is 144, indicating that one TBS includes data of 144 bits.

After determining the second transport block, the communications device obtains $I_{TBS}$ and $N_{PRB}$ from the scheduling information of the second transport block, and queries Table 1 according to $I_{TBS}$ and $N_{PRB}$, to obtain the quantity of bits in the second transport block.

After obtaining the quantity of bits in the second transport block, the communications device compares the quantity of bits in the second transport block with the first threshold, to determine the scheme for performing outer-code coding on the second transport block. The first threshold, first outer-code coding, and second outer-code coding that correspond to the quantity of bits in the second transport block are pre-stored on the communications device. The first threshold is preset by a user by comprehensively considering a quantity of bits that are allowed to be input in an outer-code coding scheme, an error correction capability of the outer-code coding scheme, and an error floor of inner-code coding, so that an error floor of inner-code coding of the second transport block can satisfy an output requirement of the second transport block.

When there is only one outer-code (RS code) coding scheme and the quantity of bits in the second transport block is greater than the first threshold that is 120 bits, the communications device performs outer-code coding on the second transport block by using a first outer code (15, 11, 2). When the quantity of bits in the second transport block is less than or equal to the first threshold that is 120 bits, the communications device does not perform outer-code coding on the second transport block.

When there are at least two outer-code (RS code) coding schemes and the quantity of bits in the second transport block is greater than the first threshold that is 120 bits, the communications device performs outer-code coding on the second transport block by using the first outer-code coding scheme (15, 11, 2). When the quantity of bits in the second transport block is less than or equal to the first threshold that is 120 bits, the communications device performs outer-code coding on the second transport block by using the second outer-code coding scheme (7, 5, 1).

An error correction capability of the first outer-code coding scheme (15, 11, 2) is stronger than an error correction capability of the second outer-code coding scheme (7, 5, 1). An error floor of the first outer-code coding scheme is lower than an error floor of the second outer-code coding scheme.

It can be understood that the first threshold is not limited to 120 bits, the first outer-code coding scheme is not limited to (15, 11, 2), and the second outer-code coding scheme is not limited to (7, 5, 1). All three may be set according to an actual status. The first outer-code coding scheme is different from the second outer-code coding scheme.

In another implementation, when the scheduling information includes the quantity of bits in the second transport block and the modulation scheme of the second transport block, the step that the communications device determines, according to the scheduling information of the second transport block, a scheme for performing outer-code coding on the second transport block is specifically as follows:

The communications device determines a second threshold according to the modulation scheme of the second transport block. When the quantity of bits in the second transport block is greater than the second threshold, the communications device determines to perform third outer-code coding on the second transport block. When the quantity of bits in the second transport block is not greater than the second threshold, the communications device determines to perform fourth outer-code coding on the second transport block, or not to perform outer-code coding.

The modulation scheme of the second transport block is specifically one or a combination of at least two of a first modulation scheme, a second modulation scheme, or a third modulation scheme. A modulation order of the first modulation scheme is higher than a modulation order of the second modulation scheme, and a second threshold corresponding to the first modulation scheme is greater than a second threshold corresponding to the second modulation scheme. The modulation scheme may include QPSK, 16QAM, and 64QAM.

A difference between this implementation and the foregoing implementation is that the first threshold in the foregoing implementation is a fixed value, whereas the second threshold in this implementation corresponds to the modulation scheme.

For example, referring to Table 2, Table 2 is a correspondence table of a modulation and coding scheme (Modulation and Coding Scheme, MCS), a modulation scheme, and a TBS index value in the PDSCH.

A correspondence table of a modulation and coding scheme, a modulation scheme, and a TBS index value in a PDSCH is stored on communications devices (a base station and a terminal). The MCS is included in scheduling information. An MCS field indicates the modulation scheme and the TBS index value. The MCS field is represented as $I_{mcs}$, the modulation scheme is represented as $Q_m$, and the TBS index value is represented as $I_{TBS}$. There is a one-to-one correspondence between $I_{mcs}$, $Q_m$, and $I_{TBS}$. A value range of $I_{mcs}$ is 0 to 32, a value of $Q_m$ is 2, 4, or 6, and a value range of the $I_{TBS}$ index value is 0 to 26. When $Q_m=2$, the modulation scheme used for the second transport block is quadrature phase shift keying (Quadrature Phase Shift Keying, QPSK). When $Q_m=4$, the modulation scheme used for the second transport block is quadrature amplitude modulation (Quadrature Amplitude Modulation, QAM) including 16 types of symbols. When $Q_m=6$, the modulation scheme used for the second transport block is 64QAM.

After determining the second transport block, the communications device obtains $I_{mcs}$ and $I_{TBS}$ from the scheduling information of the second transport block, and queries Table 2 according to $I_{mcs}$ and $I_{TBS}$, to obtain the modulation scheme of the second transport block.

After obtaining the modulation scheme of the second transport block, the communications device determines, according to the modulation scheme of the second transport block, the second threshold corresponding to the modulation scheme, and compares the quantity of bits in the second transport block with the second threshold, to determine the scheme for performing outer-code coding on the second transport block.

When the modulation scheme of the second transport block is QPSK, the communications device determines the second threshold as 256 (the second threshold is not limited thereto and may be another value) according to the modulation scheme of the second transport block.

When there is only one outer-code (RS code) coding scheme and the quantity of bits in the second transport block is greater than the second threshold that is 256 bits, the communications device performs outer-code coding on the second transport block by using a third outer code (15, 11, 2). When the quantity of bits in the second transport block is less than or equal to the second threshold that is 256 bits, the communications device does not perform outer-code coding on the second transport block.

When there are two outer-code (RS code) coding schemes and the quantity of bits in the second transport block is greater than the second threshold that is 256 bits, the communications device performs outer-code coding on the second transport block by using a third outer-code coding scheme (15, 11, 2). When the quantity of bits in the second transport block is less than or equal to the second threshold that is 256 bits, the communications device performs outer-code coding on the second transport block by using a fourth outer-code coding scheme (7, 5, 1).

When the modulation scheme is 16QAM, the communications device determines the second threshold as 1000 (the second threshold is not limited thereto and may be another value) according to the modulation scheme of the second transport block.

When there is only one outer-code (RS code) coding scheme and the quantity of bits in the second transport block is greater than the second threshold that is 1000 bits, the communications device performs outer-code coding on the second transport block by using a third outer code (15, 11, 2). When the quantity of bits in the second transport block is less than or equal to the second threshold that is 1000 bits, the communications device does not perform outer-code coding on the second transport block.

When there are at least two outer-code (RS code) coding schemes and the quantity of bits in the second transport block is greater than the second threshold that is 1000 bits, the communications device performs outer-code coding on the second transport block by using a third outer-code coding scheme (15, 11, 2). When the quantity of bits in the second transport block is less than or equal to the second threshold that is 1000 bits, the communications device performs outer-code coding on the second transport block by using a fourth outer-code coding scheme (7, 5, 1).

When the modulation scheme is 64QAM, the communications device determines the second threshold as 2000 (the second threshold is not limited thereto and may be another value) according to the modulation scheme of the second transport block.

When there is only one outer-code (RS code) coding scheme and the quantity of bits in the second transport block is greater than the second threshold that is 2000 bits, the communications device performs outer-code coding on the second transport block by using a third outer code (15, 11, 2). When the quantity of bits in the second transport block is less than or equal to the second threshold that is 1000 bits, the communications device does not perform outer-code coding on the second transport block.

When there are at least two outer-code (RS code) coding schemes and the quantity of bits in the second transport block is greater than the second threshold that is 2000 bits, the communications device performs outer-code coding on the second transport block by using a third outer-code coding scheme (15, 11, 2). When the quantity of bits in the second transport block is less than or equal to the second threshold that is 2000 bits, the communications device performs outer-code coding on the second transport block by using a fourth outer-code coding scheme (7, 5, 1).

A higher order of the modulation scheme indicates a larger quantity of bits of the second threshold corresponding to the modulation scheme. An error correction capability of the third outer-code coding scheme (15, 11, 2) is stronger than an error correction capability of the fourth outer-code coding scheme (7, 5, 1). An error floor of the third outer-code coding scheme is lower than an error floor of the fourth outer-code coding scheme.

It can be understood that the first outer-code coding scheme is not limited to (15, 11, 2), and the second outer-code coding scheme is not limited to (7, 5, 1). Both may be set according to an actual status. The third outer-code coding scheme is different from the fourth outer-code coding scheme.

The third outer-code coding scheme or the fourth outer-code coding scheme in this implementation may be the same as one of the first outer-code coding scheme or the second outer-code coding scheme in the foregoing implementation, or may be different from both the first outer-code coding scheme and the second outer-code coding scheme. This is not limited herein.

In another implementation, when the scheduling information of the second transport block includes the coding efficiency of inner-code coding, the step that the communications device determines, according to the scheduling information of the second transport block, a scheme for performing outer-code coding on the second transport block is specifically as follows:

When the coding efficiency of inner-code coding is first coding efficiency, the communications device determines to perform fifth outer-code coding on the second transport block. When the coding efficiency of inner-code coding is second coding efficiency, the communications device determines to perform sixth outer-code coding on the second transport block. The first coding efficiency is higher than the second coding efficiency, and coding efficiency of the fifth outer-code coding is lower than coding efficiency of the sixth outer-code coding. The coding efficiency is a ratio of a maximum quantity of bits that are input in operation of a coding scheme to a quantity of bits that are output after coding.

For example, still refer to Table 1 and Table 2. After determining the second transport block, the communications device obtains $I_{TBS}$ and $N_{PRB}$ from the scheduling information of the second transport block, and queries Table 1 according to $I_{TBS}$ and $N_{PRB}$, to obtain the quantity of bits in the second transport block. In addition, the communications device obtains $I_{mcs}$ and $I_{TBS}$ from the scheduling information of the second transport block, and queries Table 2 according to $I_{mcs}$ and $I_{TBS}$, to obtain the modulation scheme of the second transport block.

After obtaining the quantity of bits in the second transport block and the modulation scheme of the second transport block, the communications device calculates the coding efficiency of inner-code coding of the second transport block according to the quantity of bits in the second transport block and the modulation scheme of the second transport block.

After obtaining the coding efficiency of inner-code coding, the communications device determines, according to the coding efficiency of inner-code coding, the scheme for performing outer-code coding on the second transport block.

When there are at least two outer-code (RS code) coding schemes and the coding efficiency of inner-code coding is the first coding efficiency that is 3/4, the communications device performs outer-code coding on the fifth transport block by using a fifth outer-code coding scheme (31, 21, 3). When the coding efficiency of inner-code coding is the second coding efficiency that is 1/2, the communications device performs outer-code coding on the second transport block by using a sixth outer-code coding scheme (31, 25, 5).

An error correction capability of the fifth outer-code coding scheme (31, 21, 3) is poorer than an error correction capability of the sixth outer-code coding scheme (31, 25, 5). An error floor of the fifth outer-code coding scheme is higher than an error floor of the sixth outer-code coding scheme.

It can be understood that the first coding efficiency is not limited to 3/4, the second coding efficiency is not limited to 1/2, the fifth outer-code coding scheme is not limited to (31, 21, 3), and the sixth outer-code coding scheme is not limited to (31, 25, 5). All four may be set according to an actual status.

The fifth outer-code coding scheme is different from the sixth outer-code coding scheme. For the fifth outer-code coding scheme and the sixth outer-code coding scheme, coding schemes with different error correction capabilities may be selected according to a need and under a precondition that the coding efficiency satisfies a requirement.

The fifth outer-code coding scheme or the sixth outer-code coding scheme in this implementation may be the same as one of the first outer-code coding scheme, the second outer-code coding scheme, the third outer-code coding scheme, or the fourth outer-code coding scheme in the foregoing implementation, or may be different from all of the first outer-code coding scheme, the second outer-code coding scheme, the third outer-code coding scheme, and the fourth outer-code coding scheme. This is not limited herein.

In another implementation, when the scheduling information of the second transport block includes the quantity of bits in the second transport block and the coding efficiency of inner-code coding, the step that the communications device determines, according to the scheduling information of the second transport block, a scheme for performing outer-code coding on the second transport block is specifically as follows:

The communications device obtains the quantity of bits in the second transport block and the coding efficiency of inner-code coding from the scheduling information of the second transport block, and compares the quantity of bits in the second transport block with a first threshold corresponding to the second transport block. When the quantity of bits in the second transport block is greater than the first threshold, the communications device determines, according to the coding efficiency of inner-code coding, the scheme for performing outer-code coding on the second transport block. When the quantity of bits in the second transport block is less than or equal to the first threshold, the communications device does not perform outer-code coding on the second transport block.

A method for obtaining the quantity of bits in the second transport block and the coding efficiency of inner-code coding is the same as the obtaining method in the foregoing implementations. For specific details, refer to related descriptions in the foregoing implementations.

For example, when the quantity of bits, in the second transport block, obtained by the communications device is greater than the first threshold that is 120 bits, and the coding efficiency of inner-code coding is first coding efficiency that is 3/4, the communications device performs outer-code coding on the second transport block by using a seventh outer-code coding scheme (7, 5, 1). When the efficiency of inner-code coding is second coding efficiency that is 1/2, the communications device performs outer-code coding on the second transport block by using an eighth outer-code coding scheme (15, 11, 2). Seventh coding efficiency is higher than eighth coding efficiency, and coding efficiency of the seventh outer-code coding is lower than coding efficiency of the eighth outer-code coding.

When the quantity of bits, in the second transport block, obtained by the communications device is less than or equal to the first threshold that is 120 bits, the communications device does not perform outer-code coding on the second transport block. Certainly, in another implementation, alternatively, another outer-code coding scheme may be used to perform outer-code coding on the second transport block.

It can be understood that the first coding efficiency is not limited to 3/4, the second coding efficiency is not limited to 1/2, the seventh outer-code coding scheme is not limited to (7, 5, 1), and the eighth outer-code coding scheme is not limited to (15, 11, 2). All four may be set according to an actual status.

The seventh outer-code coding scheme is different from the eighth outer-code coding scheme. For the seventh outer-code coding scheme and the eighth outer-code coding scheme, coding schemes with different error correction capabilities may be selected according to a need and under a precondition that the coding efficiency satisfies a requirement.

The seventh outer-code coding scheme or the eighth outer-code coding scheme in this implementation may be the same as any one of the outer-code coding schemes in any one of the foregoing implementations, or may be different from all of the outer-code coding schemes in the foregoing implementations. This is not limited herein.

In another implementation, when the scheduling information of the second transport block includes the quantity of bits in the second transport block, the modulation scheme of the second transport block, and the coding efficiency of inner-code coding, the step that the communications device determines, according to the scheduling information of the second transport block, a scheme for performing outer-code coding on the second transport block is specifically as follows:

The communications device obtains the quantity of bits in the second transport block, the modulation scheme of the second transport block, and the coding efficiency of inner-code coding from the scheduling information of the second transport block, determines, according to the modulation scheme, a second threshold corresponding to the modulation scheme, and compares the quantity of bits in the second transport block with the second threshold. When the quantity of bits in the second transport block is greater than the second threshold, the communications device determines, according to the coding efficiency of inner-code coding, the scheme for performing outer-code coding on the second transport block. When the quantity of bits in the second transport block is less than or equal to the second threshold, the communications device does not perform outer-code coding on the second transport block.

A method for obtaining the quantity of bits in the second transport block, the modulation scheme of the second transport block, and the coding efficiency of inner-code coding is the same as the obtaining method in the foregoing implementations. For specific details, refer to related descriptions in the foregoing implementations.

For example, when the modulation scheme, of the second transport block, obtained by the communications device is QPSK, the corresponding second threshold is determined as 256. When the quantity of bits in the second transport block is greater than 256 bits, and the coding efficiency of inner-code coding is first coding efficiency that is 3/4, the communications device performs outer-code coding on the second transport block by using a ninth outer-code coding scheme (7, 5, 1). When the coding efficiency of inner-code coding is first coding efficiency that is 1/2, the communications device performs outer-code coding on the second transport block by using a tenth outer-code coding scheme (15, 11, 2). When the quantity of bits in the second transport block is less than or equal to 256 bits, the communications device does not perform outer-code coding on the second transport block.

When the modulation scheme, of the second transport block, obtained by the communications device is 16QAM, the corresponding second threshold is determined as 1000. When the quantity of bits in the second transport block is greater than 1000 bits and the coding efficiency of inner-code coding is first coding efficiency that is 3/4, the communications device performs outer-code coding on the second transport block by using a ninth outer-code coding scheme (15, 9, 3). When the coding efficiency of inner-code coding is first coding efficiency that is 1/2, the communications device performs outer-code coding on the second transport block by using a tenth outer-code coding scheme (31, 23, 4). When the quantity of bits in the second transport block is less than or equal to 1000 bits, the communications device does not perform outer-code coding on the second transport block.

When the modulation scheme, of the second transport block, obtained by the communications device is 64QAM, the corresponding second threshold is determined as 2000. When the quantity of bits in the second transport block is greater than 2000 bits and the coding efficiency of inner-code coding is first coding efficiency that is 3/4, the communications device performs outer-code coding on the second transport block by using a ninth outer-code coding scheme (31, 21, 3). When the coding efficiency of inner-code coding is first coding efficiency that is 1/2, the communications device performs outer-code coding on the second transport block by using a tenth outer-code coding scheme (31, 25, 5). When the quantity of bits in the second transport block is less than or equal to 1000 bits, the communications device does not perform outer-code coding on the second transport block.

The first coding efficiency is higher than the second coding efficiency, and coding efficiency of the fifth outer-code coding is lower than coding efficiency of the sixth outer-code coding. The ninth outer-code coding scheme is different from the tenth outer-code coding scheme.

It can be understood that the first coding efficiency is not limited to 3/4, the second coding efficiency is not limited to 1/2, and values of the items in the ninth outer-code coding scheme and the tenth outer-code coding scheme are not limited to the values mentioned in the foregoing coding schemes. The first coding efficiency, the second coding efficiency, and the item values may all be set according to an actual status.

The ninth outer-code coding scheme and the tenth outer-code coding scheme in this implementation may be the same as any one of the outer-code coding schemes in any one of the foregoing implementations, or may be different from all of the outer-code coding schemes in the foregoing implementations. This is not limited herein.

A higher modulation order of the modulation scheme indicates higher coding efficiency of inner-code coding and a higher error floor of inner-code coding. With a modulation order held constant, higher coding efficiency of inner-code coding indicates a higher error floor of inner-code coding. With the coding efficiency of inner-code coding held constant, a higher modulation order indicates a higher error floor of inner-code coding. For example, when the modulation scheme is 64QAM modulation, an error floor for coding efficiency of 1/2 is lower than an error floor for coding efficiency of 3/4. An error floor for coding efficiency of 3/4 and QPSK modulation is lower than an error floor for coding efficiency of 3/4 and 64QAM.

It can be understood that different outer-code coding schemes have different error correction capabilities. An error correction capability of an outer-code coding scheme determines an error floor of inner-code coding. An error correction capability of an outer-code coding scheme determines an error floor of inner-code coding.

S203: The communications device determines a third transport block, where when the scheduling information meets a preset condition, the third transport block is a transport block obtained by performing outer-code coding on the second transport block, or when the scheduling information does not meet a preset condition, the third transport block is specifically the second transport block.

Step S203 in this embodiment is the same as step S103 in the foregoing embodiment. For specific details, refer to related descriptions about step S103 in the foregoing embodiment. Details are not described herein again.

S204: The communications device performs inner-code coding on the third transport block according to a predefined rule.

Step S204 in this embodiment is the same as step S104 in the foregoing embodiment. For specific details, refer to related descriptions about step S104 in the foregoing embodiment. Details are not described herein again.

It can be understood that a coding method for the PUSCH is similar to a coding method for the PDSCH. For specific details, refer to the foregoing coding method for the PDSCH. Details are not described herein again. Decoding is a reverse process of coding. Details about a decoding process are not described herein.

The foregoing implementations are described by using the PDSCH as an example. The coding method for the PUSCH is similar to the coding method for the PDSCH. For specific details, refer to related content. Details are not described herein again.

It can be understood that the outer code in the foregoing implementations is not limited to an RS code, and may alternatively be BCH, RM, or another outer-code coding method; an inner code is not limited to Turbo, and may alternatively be a convolutional code or another inner-code coding method.

In the foregoing solution, the communications device determines the second transport block, and determines, according to the scheduling information of the second transport block, the scheme for performing outer-code coding on the second transport block, so as to determine whether to perform outer-code coding on the second transport block. After determining the third transport block, the communications device performs inner-code coding on the third transport block according to the predefined rule. In this way, a transmission resource can be effectively used, transmission resource utilization can be improved, an error floor of inner-code coding can be lowered, and data transmission reliability can be increased.

According to one or a combination of at least two of the quantity of bits in the second transport block, the modulation scheme, or the coding efficiency of inner-code coding, the communications device can select the outer-code coding scheme that matches the second transport block, so as to adjust the outer-code coding scheme in real time, make an error floor of inner-code coding satisfy a transmission requirement, and improve data transmission reliability.

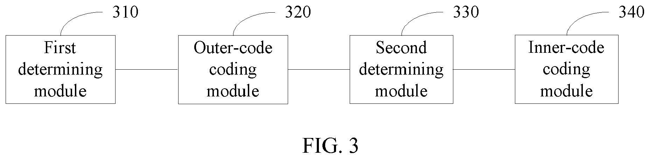

Referring to FIG. 3, FIG. 3 is a schematic structural diagram of an embodiment of a communications device in this application. The communications device may be a base station, or may be a terminal. When the communications device is a base station, a transmit end is the base station, a receive end is a terminal, and a communication channel between the base station and the terminal is a physical downlink shared channel (Physical Downlink Shared Channel, PDSCH). When the communications device is a terminal, a transmit end is the terminal, a receive end is a base station, and a communication channel between the base station and the terminal is a physical uplink shared channel (Physical Uplink Shared Channel, PUSCH).

In this embodiment, the PDSCH is used as an example for description (a coding method for the PUSCH is similar to a coding method for the PDSCH). Modules included in the communications device in this embodiment are configured to perform the steps in the embodiment corresponding to FIG. 1. For specific details, refer to FIG. 1 and related descriptions in the embodiment corresponding to the figure. Details are not described herein again. The communications device in this implementation includes a first determining module 310, an outer-code coding module 320, a second determining module 330, and an inner-code coding module 340.

The first determining module 310 is configured to determine a second transport block, where the second transport block includes a first transport block and check information corresponding to the first transport block. For example, the first determining module 310 determines a second transport block, where the second transport block includes a first transport block and check information corresponding to the first transport block. The first determining module 310 sends information about the second transport block to the outer-code coding module 320.

The outer-code coding module 320 is configured to receive the information that is about the second transport block and that is sent by the first determining module 310, determine, according to scheduling information included in the information about the second transport block, a scheme for performing outer-code coding on the second transport block, and perform outer-code coding on the second transport block by using the determined outer-code coding scheme.

For example, the outer-code coding module 320 receives the information that is about the second transport block and that is sent by the first determining module 310, determines, according to scheduling information included in the information about the second transport block, a scheme for performing outer-code coding on the second transport block, and performs, after determining the scheme for performing outer-code coding on the second transport block, outer-code coding on the second transport block by using the determined outer-code coding scheme. The outer-code coding module 320 sends, to the second determining module 330, the information about the second transport block and information about a transport block obtained by performing outer-code coding.

The second determining module 330 is configured to receive the information about the second transport block and the information about the transport block obtained by performing outer-code coding that are sent by the outer-code coding module 320, and determine a third transport block according to the scheduling information of the second transport block. When the scheduling information meets a preset condition, the third transport block is the transport block obtained by performing outer-code coding on the second transport block. When the scheduling information does not meet a preset condition, the third transport block is specifically the second transport block.

For example, the second determining module 330 receives the information about the second transport block and the information about the transport block obtained by performing outer-code coding that are sent by the outer-code coding module 320, and determines a third transport block according to the scheduling information of the second transport block. When the scheduling information meets a preset condition, the third transport block is the transport block obtained by performing outer-code coding on the second transport block. When the scheduling information does not meet a preset condition, the third transport block is specifically the second transport block. The second determining module 330 sends information about the third transport block to the inner-code coding module 340.

The inner-code coding module 340 is configured to receive the information that is about the third transport block and that is sent by the second determining module 330, and perform, according to a predefined rule, inner-code coding on the third transport block determined by the third determining module.

For example, the inner-code coding module 340 receives the information that is about the third transport block and that is sent by the second determining module 330, and performs, according to a predefined rule, inner-code coding on the third transport block determined by the third determining module.

In the foregoing solution, the communications device determines the second transport block, and determines, according to the scheduling information of the second transport block, the scheme for performing outer-code coding on the second transport block, so as to determine whether to perform outer-code coding on the second transport block. After determining the third transport block, the communications device performs inner-code coding on the third transport block according to the predefined rule. In this way, a transmission resource can be effectively used, transmission resource utilization can be improved, an error floor of inner-code coding can be lowered, and data transmission reliability can be increased.

Still referring to FIG. 3, in another embodiment, modules included in the communications device shown in FIG. 3 are configured to perform the steps in the embodiment corresponding to FIG. 2. For specific details, refer to FIG. 2 and related descriptions in the embodiment corresponding to the figure. Details are not described herein again. The communications device in this implementation includes a first determining module 310, an outer-code coding module 320, a second determining module 330, and an inner-code coding module 340.

The first determining module 310 is configured to determine a second transport block, where the second transport block includes a first transport block and check information corresponding to the first transport block. For example, the first determining module 310 determines a second transport block, where the second transport block includes a first transport block and check information corresponding to the first transport block. The first determining module 310 sends information about the second transport block to the outer-code coding module 320.

The outer-code coding module 320 is configured to receive the information that is about the second transport block and that is sent by the first determining module 310, determine, according to scheduling information included in the information about the second transport block, a scheme for performing outer-code coding on the second transport block, and perform outer-code coding on the second transport block by using the determined outer-code coding scheme. An outer code includes one or a combination of a Reed-Solomon code (Reed-Solomon Code, RS code) or a Reed-Muller code (Reed-Muller Code, RM), and the outer code includes at least one outer-code coding scheme.

For example, the outer-code coding module 320 receives the information that is about the second transport block and that is sent by the first determining module 310, determines, according to scheduling information included in the information about the second transport block, a scheme for performing outer-code coding on the second transport block, and performs, after determining the scheme for performing outer-code coding on the second transport block, outer-code coding on the second transport by using the determined outer-code coding scheme. An outer code includes one or a combination of a Reed-Solomon code (Reed-Solomon Code, RS code) or a Reed-Muller code (Reed-Muller Code, RM), and the outer code includes at least one outer-code coding scheme.

In an implementation, the scheduling information includes a quantity of bits in the second transport block. The outer-code coding module 320 is specifically configured to: when the quantity of bits in the second transport block is greater than a first threshold, perform first outer-code coding on the second transport block; or when the quantity of bits in the second transport block is not greater than a first threshold, perform second outer-code coding on the second transport block, or not perform outer-code coding.

For example, the outer-code coding module 320 receives the information that is about the second transport block and that is sent by the first determining module 310, and obtains the quantity of bits in the second transport block according to the scheduling information included in the information about the second transport block. When the quantity of bits in the second transport block is greater than a first threshold, the outer-code coding module 320 performs first outer-code coding on the second transport block. When the quantity of bits in the second transport block is not greater than a first threshold, the outer-code coding module 320 performs second outer-code coding on the second transport block, or does not perform outer-code coding.

In an implementation, the scheduling information includes a quantity of bits in the second transport block and a modulation scheme of the second transport block. The outer-code coding module 320 is specifically configured to: determine a second threshold according to the modulation scheme of the second transport block; and when the quantity of bits in the second transport block is greater than the second threshold, determine to perform third outer-code coding on the second transport block; or when the quantity of bits in the second transport block is not greater than the second threshold, determine to perform fourth outer-code coding on the second transport block, or not to perform outer-code coding. The modulation scheme of the second transport block is specifically one or a combination of at least two of a first modulation scheme, a second modulation scheme, or a third modulation scheme. A modulation order of the first modulation scheme is higher than a modulation order of the second modulation scheme, and a second threshold corresponding to the first modulation scheme is greater than a second threshold corresponding to the second modulation scheme.

For example, the outer-code coding module 320 receives the information that is about the second transport block and that is sent by the first determining module 310, obtains the quantity of bits in the second transport block and the modulation scheme of the second transport block according to the scheduling information included in the information about the second transport block, and determines a second threshold according to the modulation scheme of the second transport block.

When the quantity of bits in the second transport block is greater than the second threshold, the outer-code coding module 320 determines to perform third outer-code coding on the second transport block. When the quantity of bits in the second transport block is not greater than the second threshold, the outer-code coding module 320 determines to perform fourth outer-code coding on the second transport block, or not to perform outer-code coding.

The modulation scheme of the second transport block is specifically one or a combination of at least two of a first modulation scheme, a second modulation scheme, or a third modulation scheme. A modulation order of the first modulation scheme is higher than a modulation order of the second modulation scheme, and a second threshold corresponding to the first modulation scheme is greater than a second threshold corresponding to the second modulation scheme.

In another implementation, the scheduling information includes coding efficiency of inner-code coding. The outer-code coding module 320 is specifically configured to: when the coding efficiency of inner-code coding is first coding efficiency, determine to perform fifth outer-code coding on the second transport block; or when the coding efficiency of inner-code coding is second coding efficiency, determine to perform sixth outer-code coding on the second transport block. The first coding efficiency is higher than the second coding efficiency, and coding efficiency of the fifth outer-code coding is lower than coding efficiency of the sixth outer-code coding.

For example, the outer-code coding module 320 receives the information that is about the second transport block and that is sent by the first determining module 310, and obtains the coding efficiency of inner-code coding according to the scheduling information included in the information about the second transport block. When the coding efficiency of inner-code coding is first coding efficiency, the outer-code coding module 320 determines to perform fifth outer-code coding on the second transport block. When the coding efficiency of inner-code coding is second coding efficiency, the outer-code coding module 320 determines to perform sixth outer-code coding on the second transport block. The first coding efficiency is higher than the second coding efficiency, and coding efficiency of the fifth outer-code coding is lower than coding efficiency of the sixth outer-code coding.

The outer-code coding module 320 sends, to the second determining module 330, the information about the second transport block and information about a transport block obtained by performing outer-code coding.

The second determining module 330 is configured to receive the information about the second transport block and the information about the transport block obtained by performing outer-code coding that are sent by the outer-code coding module 320, and determine a third transport block according to the scheduling information of the second transport block. When the scheduling information meets a preset condition, the third transport block is the transport block obtained by performing outer-code coding on the second transport block. When the scheduling information does not meet a preset condition, the third transport block is specifically the second transport block.

For example, the second determining module 330 receives the information about the second transport block and the information about the transport block obtained by performing outer-code coding that are sent by the outer-code coding module 320, and determines a third transport block according to the scheduling information of the second transport block. When the scheduling information meets a preset condition, the third transport block is the transport block obtained by performing outer-code coding on the second transport block. When the scheduling information does not meet a preset condition, the third transport block is specifically the second transport block. The second determining module 330 sends information about the third transport block to the inner-code coding module 340.

The inner-code coding module 340 is configured to receive the information that is about the third transport block and that is sent by the second determining module 330, and perform, according to a predefined rule, inner-code coding on the third transport block determined by the third determining module.

For example, the inner-code coding module 340 receives the information that is about the third transport block and that is sent by the second determining module 330, and performs, according to a predefined rule, inner-code coding on the third transport block determined by the third determining module.

In the foregoing solution, the communications device determines the second transport block, and determines, according to the scheduling information of the second transport block, the scheme for performing outer-code coding on the second transport block, so as to determine whether to perform outer-code coding on the second transport block. After determining the third transport block, the communications device performs inner-code coding on the third transport block according to the predefined rule. In this way, a transmission resource can be effectively used, transmission resource utilization can be improved, an error floor of inner-code coding can be lowered, and data transmission reliability can be increased.

According to one or a combination of at least two of the quantity of bits in the second transport block, the modulation scheme, or the coding efficiency of inner-code coding, the communications device can select the outer-code coding scheme that matches the second transport block, so as to adjust the outer-code coding scheme in real time, make an error floor of inner-code coding satisfy a transmission requirement, and improve data transmission reliability.

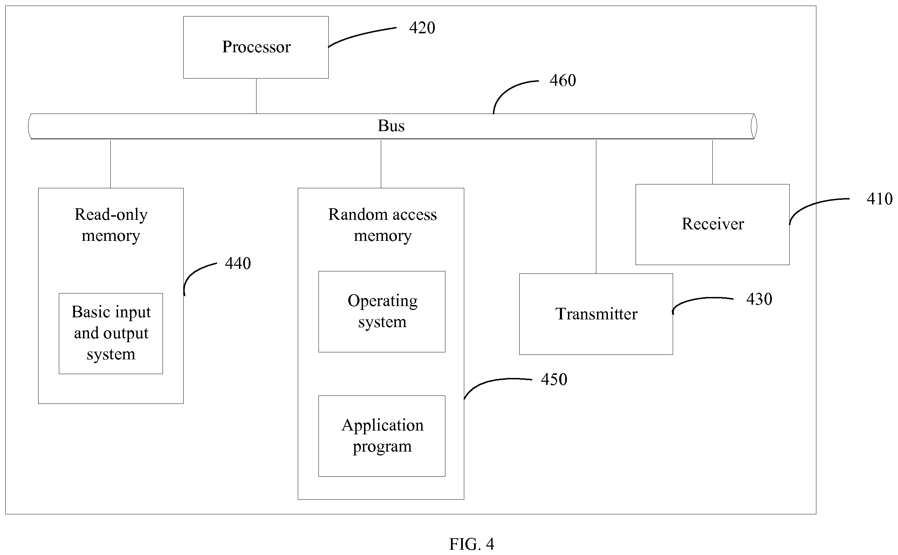

Referring to FIG. 4, FIG. 4 is a schematic structural diagram of another embodiment of a communications device in this application. The communications device may be a base station, or may be a terminal. When the communications device is a base station, a transmit end is the base station, a receive end is a terminal, and a communication channel between the base station and the terminal is a physical downlink shared channel (Physical Downlink Shared Channel, PDSCH). When the communications device is a terminal, a transmit end is the terminal, a receive end is a base station, and a communication channel between the base station and the terminal is a physical uplink shared channel (Physical Uplink Shared Channel, PUSCH).

The communications device in this embodiment includes a receiver 410, a processor 420, a transmitter 430, a read-only memory 440, a random access memory 450, and a bus 460.

The receiver 410 is configured to receive a signal.

The processor 420 controls an operation of the communications device. The processor 420 may also be referred to as a CPU (Central Processing Unit, central processing unit). The processor 420 may be an integrated circuit chip and has a signal processing capability. Alternatively, the processor 420 may be a general purpose processor, a digital signal processor (DSP), an application-specific integrated circuit (ASIC), a field programmable gate array (FPGA) or another programmable logic device, a discrete gate or a transistor logic device, or a discrete hardware component. The general purpose processor may be a microprocessor, or the processor may be any conventional processor or the like.

The transmitter 430 is configured to send a signal.

A memory may include the read-only memory 440 and the random access memory 450, and provides an instruction and data for the processor 420. A part of the memory may further include a nonvolatile random access memory (NVRAM).

All components of the communications device are coupled to each other by using the bus 460. In addition to a data bus, the bus 460 may further include a power bus, a control bus, a status signal bus, and the like. However, for clear description, various buses in the figure are all marked as the bus 460.

The memory stores the following elements, that is, an executable module or a data structure, or subsets thereof, or extended sets thereof:

> an operation instruction: including various operation instructions, used to implement various operations; and
> an operating system: including various system programs, configured to implement various basic services and process hardware-based tasks.

In this embodiment of the present invention, the processor 420 invokes the operation instruction (the operation instruction may be stored in the operating system) stored in the memory, to execute the following operations:

The processor 420 is configured to control the memory to store data.

The processor 420 is configured to determine a second transport block, where the second transport block includes a first transport block and check information corresponding to the first transport block.

The processor 420 is further configured to determine, according to scheduling information of the second transport block, a scheme for performing outer-code coding on the second transport block, and perform outer-code coding on the second transport block by using the determined outer-code coding scheme.

The processor 420 is further configured to determine a third transport block according to the scheduling information of the second transport block. When the scheduling information meets a preset condition, the third transport block is a transport block obtained by performing outer-code coding on the second transport block. When the scheduling information does not meet a preset condition, the third transport block is specifically the second transport block.

The processor 420 is further configured to perform inner-code coding on the third transport block according to a predefined rule.

The scheduling information includes a quantity of bits in the second transport block. The processor 420 is specifically configured to: when the quantity of bits in the second transport block is greater than a first threshold, perform first outer-code coding on the second transport block; or when the quantity of bits in the second transport block is not greater than a first threshold, perform second outer-code coding on the second transport block, or not perform outer-code coding.

The scheduling information includes a quantity of bits in the second transport block and a modulation scheme of the second transport block. The processor 420 is specifically configured to: determine a second threshold according to the modulation scheme of the second transport block; and when the quantity of bits in the second transport block is greater than the second threshold, determine to perform third outer-code coding on the second transport block; or when the quantity of bits in the second transport block is not greater than the second threshold, determine to perform fourth outer-code coding on the second transport block, or not to perform outer-code coding. The modulation scheme of the second transport block is specifically one or a combination of at least two of a first modulation scheme, a second modulation scheme, or a third modulation scheme. A modulation order of the first modulation scheme is higher than a modulation order of the second modulation scheme, and a second threshold corresponding to the first modulation scheme is greater than a second threshold corresponding to the second modulation scheme.

The scheduling information includes coding efficiency of inner-code coding. The processor 420 is specifically configured to: when the coding efficiency of inner-code coding is first coding efficiency, determine to perform fifth outer-code coding on the second transport block; or when the coding efficiency of inner-code coding is second coding efficiency, determine to perform sixth outer-code coding on the second transport block. The first coding efficiency is higher than the second coding efficiency, and coding efficiency of the fifth outer-code coding is lower than coding efficiency of the sixth outer-code coding.

An outer code includes one or a combination of a Reed-Solomon code (Reed-Solomon Code, RS code) or a Reed-Muller code (Reed-Muller Code, RM), and the outer code includes at least one outer-code coding scheme.

In the foregoing solution, the communications device determines the second transport block, and determines, according to the scheduling information of the second transport block, the scheme for performing outer-code coding on the second transport block, so as to determine whether to perform outer-code coding on the second transport block. After determining the third transport block, the communications device performs inner-code coding on the third transport block according to the predefined rule. In this way, a transmission resource can be effectively used, transmission resource utilization can be improved, an error floor of inner-code coding can be lowered, and data transmission reliability can be increased.

In the foregoing descriptions, for a purpose of illustration rather than limitation, specific details such as a particular system structure, interface, and technology are provided, to facilitate thorough understanding of this application. However, a person skilled in the art should know that this application may also be implemented in another implementation without these specific details. In other cases, detailed descriptions about well-known apparatuses, circuits, and methods are omitted, so that this application is described without being obscured by unnecessary details.

**Claims**

1. A coding method, wherein the method comprises:

    determining, by a communications device, a second transport block, wherein the second transport block comprises a first transport block and check information corresponding to the first transport block;
    determining, by the communications device according to scheduling information of the second transport block, a scheme for performing outer-code coding on the second transport block;
    determining, by the communications device, a third transport block, wherein when the scheduling information meets a preset condition, the third transport block is a transport block obtained by performing outer-code coding on the second transport block, or when the scheduling information does not meet a preset condition, the third transport block is specifically the second transport block; and
    performing, by the communications device, inner-code coding on the third transport block according to a predefined rule.

2. The method according to claim 1, wherein the scheduling information comprises a quantity of bits in the second transport block; and
    the determining, by the communications device according to scheduling information of the second transport block, a scheme for performing outer-code coding on the second transport block comprises:

    when the quantity of bits in the second transport block is greater than a first threshold, performing, by the communications device, first outer-code coding on the second transport block; or
    when the quantity of bits in the second transport block is not greater than a first threshold, performing, by the communications device, second outer-code coding on the second transport block, or skipping performing outer-code coding.

3. The method according to claim 1, wherein the scheduling information comprises a quantity of bits in the second transport block and a modulation scheme of the second transport block; and
    the determining, by the communications device according to scheduling information of the second transport block, a scheme for performing outer-code coding on the second transport block comprises:

determining, by the communications device, a second threshold according to the modulation scheme of the second transport block; and when the quantity of bits in the second transport block is greater than the second threshold, determining, by the communications device, to perform third outer-code coding on the second transport block; or when the quantity of bits in the second transport block is not greater than the second threshold, determining, by the communications device, to perform fourth outer-code coding on the second transport block, or to skip performing outer-code coding, wherein

the modulation scheme of the second transport block is specifically one or a combination of at least two of a first modulation scheme, a second modulation scheme, or a third modulation scheme, a modulation order of the first modulation scheme is higher than a modulation order of the second modulation scheme, and a second threshold corresponding to the first modulation scheme is greater than a second threshold corresponding to the second modulation scheme.

4. The method according to any one of claims 1 to 3, wherein the scheduling information comprises coding efficiency of inner-code coding; and

the determining, by the communications device according to scheduling information of the second transport block, a scheme for performing outer-code coding on the second transport block comprises:

when the coding efficiency of inner-code coding is first coding efficiency, determining, by the communications device, to perform fifth outer-code coding on the second transport block; or when the coding efficiency of inner-code coding is second coding efficiency, determining, by the communications device, to perform sixth outer-code coding on the second transport block, wherein

the first coding efficiency is higher than the second coding efficiency, and coding efficiency of the fifth outer-code coding is lower than coding efficiency of the sixth outer-code coding.

5. The method according to claim 1, wherein an outer code comprises one or a combination of a Reed-Solomon code (Reed-Solomon Code, RS code) or a Reed-Muller code (Reed-Muller Code, RM), and the outer code comprises at least one outer-code coding scheme.

6. A communications device, wherein the communications device comprises a first determining module, an outer-code coding module, a second determining module, and an inner-code coding module;

the first determining module is configured to determine a second transport block, wherein the second transport block comprises a first transport block and check information corresponding to the first transport block;

the outer-code coding module is configured to determine, according to scheduling information of the second transport block determined by the first determining module, a scheme for performing outer-code coding on the second transport block, and perform outer-code coding on the second transport block by using the determined outer-code coding scheme;

the second determining module is configured to determine a third transport block according to the scheduling information of the second transport block, wherein when the scheduling information meets a preset condition, the third transport block is a transport block obtained by performing outer-code coding on the second transport block, or when the scheduling information does not meet a preset condition, the third transport block is specifically the second transport block; and

the inner-code coding module is configured to perform, according to a predefined rule, inner-code coding on the third transport block determined by the second determining module.

7. The communications device according to claim 6, wherein the scheduling information comprises a quantity of bits in the second transport block; and

the outer-code coding module is specifically configured to: when the quantity of bits in the second transport block is greater than a first threshold, perform first outer-code coding on the second transport block; or when the quantity of bits in the second transport block is not greater than a first threshold, perform second outer-code coding on the second transport block, or skip performing outer-code coding.

8. The communications device according to claim 6, wherein the scheduling information comprises a quantity of bits in the second transport block and a modulation scheme of the second transport block; and

the outer-code coding module is specifically configured to: determine a second threshold according to the modulation scheme of the second transport block; and when the quantity of bits in the second transport block is greater than the second threshold, determine to perform third outer-code coding on the second transport block; or when the quantity of bits in the second transport block is not greater than the second threshold, determine to perform fourth outer-code coding on the second transport block, or to skip performing outer-code coding, wherein

the modulation scheme of the second transport block is specifically one or a combination of at least two of a first modulation scheme, a second modulation scheme, or a third modulation scheme, a modulation order of the first modulation scheme is higher than a modulation order of the second modulation scheme, and a second threshold corresponding to the first modulation scheme is greater than a second threshold corresponding to the second modulation scheme.

9. The communications device according to any one of claims 6 to 8, wherein the scheduling information comprises coding efficiency of inner-code coding; and
the outer-code coding module is specifically configured to: when the coding efficiency of inner-code coding is first coding efficiency, determine to perform fifth outer-code coding on the second transport block; or when the coding efficiency of inner-code coding is second coding efficiency, determine to perform sixth outer-code coding on the second transport block, wherein
the first coding efficiency is higher than the second coding efficiency, and coding efficiency of the fifth outer-code coding is lower than coding efficiency of the sixth outer-code coding.

10. The communications device according to claim 6, wherein an outer code comprises one or a combination of a Reed-Solomon code (Reed-Solomon Code, RS code) or a Reed-Muller code (Reed-Muller Code, RM), and the outer code comprises at least one outer-code coding scheme.

11. A communications device, wherein the communications device comprises a memory and a processor;
the memory is configured to store data;
the processor is configured to determine a second transport block, wherein the second transport block comprises a first transport block and check information corresponding to the first transport block;
the processor is further configured to determine, according to scheduling information of the second transport block, a scheme for performing outer-code coding on the second transport block, and perform outer-code coding on the second transport block by using the determined outer-code coding scheme;
the processor is further configured to determine a third transport block according to the scheduling information of the second transport block, wherein when the scheduling information meets a preset condition, the third transport block is a transport block obtained by performing outer-code coding on the second transport block, or when the scheduling information does not meet a preset condition, the third transport block is specifically the second transport block; and
the processor is further configured to perform inner-code coding on the third transport block according to a predefined rule.

12. The communications device according to claim 11, wherein the scheduling information comprises a quantity of bits in the second transport block; and
the processor is specifically configured to: when the quantity of bits in the second transport block is greater than a first threshold, perform first outer-code coding on the second transport block; or when the quantity of bits in the second transport block is not greater than a first threshold, perform second outer-code coding on the second transport block, or skip performing outer-code coding.

13. The communications device according to claim 11, wherein the scheduling information comprises a quantity of bits in the second transport block and a modulation scheme of the second transport block; and
the processor is specifically configured to: determine a second threshold according to the modulation scheme of the second transport block; and when the quantity of bits in the second transport block is greater than the second threshold, determine to perform third outer-code coding on the second transport block; or when the quantity of bits in the second transport block is not greater than the second threshold, determine to perform fourth outer-code coding on the second transport block, or to skip performing outer-code coding, wherein
the modulation scheme of the second transport block is specifically one or a combination of at least two of a first modulation scheme, a second modulation scheme, or a third modulation scheme, a modulation order of the first modulation scheme is higher than a modulation order of the second modulation scheme, and a second threshold corresponding to the first modulation scheme is greater than a second threshold corresponding to the second modulation scheme.

14. The communications device according to any one of claims 11 to 13, wherein the scheduling information comprises coding efficiency of inner-code coding; and
the processor is specifically configured to: when the coding efficiency of inner-code coding is first coding efficiency, determine to perform fifth outer-code coding on the second transport block; or when the coding efficiency of inner-code coding is second coding efficiency, determine to perform sixth outer-code coding on the second transport block, wherein
the first coding efficiency is higher than the second coding efficiency, and coding efficiency of the fifth outer-code coding is lower than coding efficiency of the sixth outer-code coding.

15. The communications device according to claim 11, wherein an outer code comprises one or a combination of a Reed-Solomon code (Reed-Solomon Code, RS code) or a Reed-Muller code (Reed-Muller Code, RM), and the outer code comprises at least one outer-code coding scheme.

S101

A communications device determines a second transport block, where the second transport block includes a first transport block and check information corresponding to the first transport block

S102

The communications device determines, according to scheduling information of the second transport block, a scheme for performing outer-code coding on the second transport block

S103

The communications device determines a third transport block, where when the scheduling information meets a preset condition, the third transport block is a transport block obtained by performing outer-code coding on the second transport block, or when the scheduling information does not meet a preset condition, the third transport block is specifically the second transport block

S104

The communications device performs inner-code coding on the third transport block according to a predefined rule

FIG. 1

S201

A communications device determines a second transport block, where the second transport block includes a first transport block and check information corresponding to the first transport block

S202

The communications device determines, according to scheduling information of the second transport block, a scheme for performing outer-code coding on the second transport block, where the scheduling information includes one or a combination of a quantity of bits in the second transport block, a modulation scheme of the second transport block, or coding efficiency of inner-code coding

S203

The communications device determines a third transport block, where when the scheduling information meets a preset condition, the third transport block is a transport block obtained by performing outer-code coding on the second transport block, or when the scheduling information does not meet a preset condition, the third transport block is specifically the second transport block

S204

The communications device performs inner-code coding on the third transport block according to a predefined rule

FIG. 2

Table 1: TBS table in which one codeword is mapped to one layer

| $I_{TBS}$ | $N_{PRB}$ | | | | | | | | | |
|---|---|---|---|---|---|---|---|---|---|---|
| | 1 | 2 | 3 | 4 | 5 | 6 | 7 | 8 | 9 | 10 |
| 0 | 16 | 32 | 56 | 88 | 120 | 152 | 176 | 208 | 224 | 256 |
| 1 | 24 | 56 | 88 | 144 | 176 | 208 | 224 | 256 | 328 | 344 |
| 2 | 32 | 72 | 144 | 176 | 208 | 256 | 296 | 328 | 376 | 424 |
| 3 | 40 | 104 | 176 | 208 | 256 | 328 | 392 | 440 | 504 | 568 |
| 4 | 56 | 120 | 208 | 256 | 328 | 408 | 488 | 552 | 632 | 696 |
| 5 | 72 | 144 | 224 | 328 | 424 | 504 | 600 | 680 | 776 | 872 |
| 6 | 328 | 176 | 256 | 392 | 504 | 600 | 712 | 808 | 936 | 1032 |
| 7 | 104 | 224 | 328 | 472 | 584 | 712 | 840 | 968 | 1096 | 1224 |
| 8 | 120 | 256 | 392 | 536 | 680 | 808 | 968 | 1096 | 1256 | 1384 |
| 9 | 136 | 296 | 456 | 616 | 776 | 936 | 1096 | 1256 | 1416 | 1544 |
| 10 | 144 | 328 | 504 | 680 | 872 | 1032 | 1224 | 1384 | 1544 | 1736 |
| 11 | 176 | 376 | 584 | 776 | 1000 | 1192 | 1384 | 1608 | 1800 | 2024 |
| 12 | 208 | 440 | 680 | 904 | 1128 | 1352 | 1608 | 1800 | 2024 | 2280 |
| 13 | 224 | 488 | 744 | 1000 | 1256 | 1544 | 1800 | 2024 | 2280 | 2536 |
| 14 | 256 | 552 | 840 | 1128 | 1416 | 1736 | 1992 | 2280 | 2600 | 2856 |
| 15 | 280 | 600 | 904 | 1224 | 1544 | 1800 | 2152 | 2472 | 2728 | 3112 |
| 16 | 328 | 632 | 968 | 1288 | 1608 | 1928 | 2280 | 2600 | 2984 | 3240 |
| 17 | 336 | 696 | 1064 | 1416 | 1800 | 2152 | 2536 | 2856 | 3240 | 3624 |
| 18 | 376 | 776 | 1160 | 1544 | 1992 | 2344 | 2792 | 3112 | 3624 | 4008 |
| 19 | 408 | 840 | 1288 | 1736 | 2152 | 2600 | 2984 | 3496 | 3880 | 4264 |
| 20 | 440 | 904 | 1384 | 1864 | 2344 | 2792 | 3240 | 3752 | 4136 | 4584 |
| 21 | 488 | 1000 | 1480 | 1992 | 2472 | 2984 | 3496 | 4008 | 4584 | 4968 |
| 22 | 520 | 1064 | 1608 | 2152 | 2664 | 3240 | 3752 | 4264 | 4776 | 5352 |
| 23 | 552 | 1128 | 1736 | 2280 | 2856 | 3496 | 4008 | 4584 | 5160 | 5736 |
| 24 | 584 | 1192 | 1800 | 2408 | 2984 | 3624 | 4264 | 4968 | 5544 | 5992 |
| 25 | 616 | 1256 | 1864 | 2536 | 3112 | 3752 | 4392 | 5160 | 5736 | 6200 |
| 26 | 712 | 1480 | 2216 | 2984 | 3752 | 4392 | 5160 | 5992 | 6712 | 7480 |

Table 1 continued

| $I_{TBS}$ | $N_{PRB}$ | | | | | | | | | |
|---|---|---|---|---|---|---|---|---|---|---|
| | 11 | 12 | 13 | 14 | 15 | 16 | 17 | 18 | 19 | 20 |
| 0 | 288 | 328 | 344 | 376 | 392 | 424 | 456 | 488 | 504 | 536 |
| 1 | 376 | 424 | 456 | 488 | 520 | 568 | 600 | 632 | 680 | 712 |
| 2 | 472 | 520 | 568 | 616 | 648 | 696 | 744 | 776 | 840 | 872 |
| 3 | 616 | 680 | 744 | 808 | 872 | 904 | 968 | 1032 | 1096 | 1160 |
| 4 | 776 | 840 | 904 | 1000 | 1064 | 1128 | 1192 | 1288 | 1352 | 1416 |
| 5 | 968 | 1032 | 1128 | 1224 | 1320 | 1384 | 1480 | 1544 | 1672 | 1736 |
| 6 | 1128 | 1224 | 1352 | 1480 | 1544 | 1672 | 1736 | 1864 | 1992 | 2088 |
| 7 | 1320 | 1480 | 1608 | 1672 | 1800 | 1928 | 2088 | 2216 | 2344 | 2472 |
| 8 | 1544 | 1672 | 1800 | 1928 | 2088 | 2216 | 2344 | 2536 | 2664 | 2792 |
| 9 | 1736 | 1864 | 2024 | 2216 | 2344 | 2536 | 2664 | 2856 | 2984 | 3112 |
| 10 | 1928 | 2088 | 2280 | 2472 | 2664 | 2792 | 2984 | 3112 | 3368 | 3496 |
| 11 | 2216 | 2408 | 2600 | 2792 | 2984 | 3240 | 3496 | 3624 | 3880 | 4008 |
| 12 | 2472 | 2728 | 2984 | 3240 | 3368 | 3624 | 3880 | 4136 | 4392 | 4584 |
| 13 | 2856 | 3112 | 3368 | 3624 | 3880 | 4136 | 4392 | 4584 | 4968 | 5160 |
| 14 | 3112 | 3496 | 3752 | 4008 | 4264 | 4584 | 4968 | 5160 | 5544 | 5736 |
| 15 | 3368 | 3624 | 4008 | 4264 | 4584 | 4968 | 5160 | 5544 | 5736 | 6200 |
| 16 | 3624 | 3880 | 4264 | 4584 | 4968 | 5160 | 5544 | 5992 | 6200 | 6456 |
| 17 | 4008 | 4392 | 4776 | 5160 | 5352 | 5736 | 6200 | 6456 | 6712 | 7224 |
| 18 | 4392 | 4776 | 5160 | 5544 | 5992 | 6200 | 6712 | 7224 | 7480 | 7992 |
| 19 | 4776 | 5160 | 5544 | 5992 | 6456 | 6968 | 7224 | 7736 | 8248 | 8504 |
| 20 | 5160 | 5544 | 5992 | 6456 | 6968 | 7480 | 7992 | 8248 | 8760 | 9144 |
| 21 | 5544 | 5992 | 6456 | 6968 | 7480 | 7992 | 8504 | 9144 | 9528 | 9912 |
| 22 | 5992 | 6456 | 6968 | 7480 | 7992 | 8504 | 9144 | 9528 | 10296 | 10680 |
| 23 | 6200 | 6968 | 7480 | 7992 | 8504 | 9144 | 9912 | 10296 | 11064 | 11448 |
| 24 | 6712 | 7224 | 7992 | 8504 | 9144 | 9912 | 10296 | 11064 | 11448 | 12216 |
| 25 | 6968 | 7480 | 8248 | 8760 | 9528 | 10296 | 10680 | 11448 | 12216 | 12576 |

| 26 | 8248 | 8760 | 9528 | 10296 | 11064 | 11832 | 12576 | 13536 | 14112 | 14688 |

Table 1 continued

| $I_{TBS}$ | $N_{PRB}$ | | | | | | | | | |
|---|---|---|---|---|---|---|---|---|---|---|
| | 21 | 22 | 23 | 24 | 25 | 26 | 27 | 28 | 29 | 30 |
| 0 | 568 | 600 | 616 | 648 | 680 | 712 | 744 | 776 | 776 | 808 |
| 1 | 744 | 776 | 808 | 872 | 904 | 936 | 968 | 1000 | 1032 | 1064 |
| 2 | 936 | 968 | 1000 | 1064 | 1096 | 1160 | 1192 | 1256 | 1288 | 1320 |
| 3 | 1224 | 1256 | 1320 | 1384 | 1416 | 1480 | 1544 | 1608 | 1672 | 1736 |
| 4 | 1480 | 1544 | 1608 | 1736 | 1800 | 1864 | 1928 | 1992 | 2088 | 2152 |
| 5 | 1864 | 1928 | 2024 | 2088 | 2216 | 2280 | 2344 | 2472 | 2536 | 2664 |
| 6 | 2216 | 2280 | 2408 | 2472 | 2600 | 2728 | 2792 | 2984 | 2984 | 3112 |
| 7 | 2536 | 2664 | 2792 | 2984 | 3112 | 3240 | 3368 | 3368 | 3496 | 3624 |
| 8 | 2984 | 3112 | 3240 | 3368 | 3496 | 3624 | 3752 | 3880 | 4008 | 4264 |
| 9 | 3368 | 3496 | 3624 | 3752 | 4008 | 4136 | 4264 | 4392 | 4584 | 4776 |
| 10 | 3752 | 3880 | 4008 | 4264 | 4392 | 4584 | 4776 | 4968 | 5160 | 5352 |
| 11 | 4264 | 4392 | 4584 | 4776 | 4968 | 5352 | 5544 | 5736 | 5992 | 5992 |
| 12 | 4776 | 4968 | 5352 | 5544 | 5736 | 5992 | 6200 | 6456 | 6712 | 6712 |
| 13 | 5352 | 5736 | 5992 | 6200 | 6456 | 6712 | 6968 | 7224 | 7480 | 7736 |
| 14 | 5992 | 6200 | 6456 | 6968 | 7224 | 7480 | 7736 | 7992 | 8248 | 8504 |
| 15 | 6456 | 6712 | 6968 | 7224 | 7736 | 7992 | 8248 | 8504 | 8760 | 9144 |
| 16 | 6712 | 7224 | 7480 | 7736 | 7992 | 8504 | 8760 | 9144 | 9528 | 9912 |
| 17 | 7480 | 7992 | 8248 | 8760 | 9144 | 9528 | 9912 | 10296 | 10296 | 10680 |
| 18 | 8248 | 8760 | 9144 | 9528 | 9912 | 10296 | 10680 | 11064 | 11448 | 11832 |
| 19 | 9144 | 9528 | 9912 | 10296 | 10680 | 11064 | 11448 | 12216 | 12576 | 12960 |
| 20 | 9912 | 10296 | 10680 | 11064 | 11448 | 12216 | 12576 | 12960 | 13536 | 14112 |
| 21 | 10680 | 11064 | 11448 | 12216 | 12576 | 12960 | 13536 | 14112 | 14688 | 15264 |
| 22 | 11448 | 11832 | 12576 | 12960 | 13536 | 14112 | 14688 | 15264 | 15840 | 16416 |
| 23 | 12216 | 12576 | 12960 | 13536 | 14112 | 14688 | 15264 | 15840 | 16416 | 16992 |
| 24 | 12960 | 13536 | 14112 | 14688 | 15264 | 15840 | 16416 | 16992 | 17568 | 18336 |
| 25 | 13536 | 14112 | 14688 | 15264 | 15840 | 16416 | 16992 | 17568 | 18336 | 19080 |

| 26 | 15264 | 16416 | 16992 | 17568 | 18336 | 19080 | 19848 | 20616 | 21384 | 22152 |

Table 1 continued

| $I_{TBS}$ | $N_{PRB}$ | | | | | | | | | |
|---|---|---|---|---|---|---|---|---|---|---|
| | 31 | 32 | 33 | 34 | 35 | 36 | 37 | 38 | 39 | 40 |
| 0 | 840 | 872 | 904 | 936 | 968 | 1000 | 1032 | 1032 | 1064 | 1096 |
| 1 | 1128 | 1160 | 1192 | 1224 | 1256 | 1288 | 1352 | 1384 | 1416 | 1416 |
| 2 | 1384 | 1416 | 1480 | 1544 | 1544 | 1608 | 1672 | 1672 | 1736 | 1800 |
| 3 | 1800 | 1864 | 1928 | 1992 | 2024 | 2088 | 2152 | 2216 | 2280 | 2344 |
| 4 | 2216 | 2280 | 2344 | 2408 | 2472 | 2600 | 2664 | 2728 | 2792 | 2856 |
| 5 | 2728 | 2792 | 2856 | 2984 | 3112 | 3112 | 3240 | 3368 | 3496 | 3496 |
| 6 | 3240 | 3368 | 3496 | 3496 | 3624 | 3752 | 3880 | 4008 | 4136 | 4136 |
| 7 | 3752 | 3880 | 4008 | 4136 | 4264 | 4392 | 4584 | 4584 | 4776 | 4968 |
| 8 | 4392 | 4584 | 4584 | 4776 | 4968 | 4968 | 5160 | 5352 | 5544 | 5544 |
| 9 | 4968 | 5160 | 5160 | 5352 | 5544 | 5736 | 5736 | 5992 | 6200 | 6200 |
| 10 | 5544 | 5736 | 5736 | 5992 | 6200 | 6200 | 6456 | 6712 | 6712 | 6968 |
| 11 | 6200 | 6456 | 6712 | 6968 | 6968 | 7224 | 7480 | 7736 | 7736 | 7992 |
| 12 | 6968 | 7224 | 7480 | 7736 | 7992 | 8248 | 8504 | 8760 | 8760 | 9144 |
| 13 | 7992 | 8248 | 8504 | 8760 | 9144 | 9144 | 9528 | 9912 | 9912 | 10296 |
| 14 | 8760 | 9144 | 9528 | 9912 | 9912 | 10296 | 10680 | 11064 | 11064 | 11448 |
| 15 | 9528 | 9912 | 10296 | 10296 | 10680 | 11064 | 11448 | 11832 | 11832 | 12216 |
| 16 | 9912 | 10296 | 10680 | 11064 | 11448 | 11832 | 12216 | 12216 | 12576 | 12960 |
| 17 | 11064 | 11448 | 11832 | 12216 | 12576 | 12960 | 13536 | 13536 | 14112 | 14688 |
| 18 | 12216 | 12576 | 12960 | 13536 | 14112 | 14112 | 14688 | 15264 | 15264 | 15840 |
| 19 | 13536 | 13536 | 14112 | 14688 | 15264 | 15264 | 15840 | 16416 | 16992 | 16992 |
| 20 | 14688 | 14688 | 15264 | 15840 | 16416 | 16992 | 16992 | 17568 | 18336 | 18336 |
| 21 | 15840 | 15840 | 16416 | 16992 | 17568 | 18336 | 18336 | 19080 | 19848 | 19848 |
| 22 | 16992 | 16992 | 17568 | 18336 | 19080 | 19080 | 19848 | 20616 | 21384 | 21384 |
| 23 | 17568 | 18336 | 19080 | 19848 | 19848 | 20616 | 21384 | 22152 | 22152 | 22920 |
| 24 | 19080 | 19848 | 19848 | 20616 | 21384 | 22152 | 22920 | 22920 | 23688 | 24496 |
| 25 | 19848 | 20616 | 20616 | 21384 | 22152 | 22920 | 23688 | 24496 | 24496 | 25456 |

| 26 | 22920 | 23688 | 24496 | 25456 | 25456 | 26416 | 27376 | 28336 | 29296 | 29296 |

Table 1 continued

| $I_{TBS}$ | $N_{PRB}$ | | | | | | | | | |
|---|---|---|---|---|---|---|---|---|---|---|
| | 41 | 42 | 43 | 44 | 45 | 46 | 47 | 48 | 49 | 50 |
| 0 | 1128 | 1160 | 1192 | 1224 | 1256 | 1256 | 1288 | 1320 | 1352 | 1384 |
| 1 | 1480 | 1544 | 1544 | 1608 | 1608 | 1672 | 1736 | 1736 | 1800 | 1800 |
| 2 | 1800 | 1864 | 1928 | 1992 | 2024 | 2088 | 2088 | 2152 | 2216 | 2216 |
| 3 | 2408 | 2472 | 2536 | 2536 | 2600 | 2664 | 2728 | 2792 | 2856 | 2856 |
| 4 | 2984 | 2984 | 3112 | 3112 | 3240 | 3240 | 3368 | 3496 | 3496 | 3624 |
| 5 | 3624 | 3752 | 3752 | 3880 | 4008 | 4008 | 4136 | 4264 | 4392 | 4392 |
| 6 | 4264 | 4392 | 4584 | 4584 | 4776 | 4776 | 4968 | 4968 | 5160 | 5160 |
| 7 | 4968 | 5160 | 5352 | 5352 | 5544 | 5736 | 5736 | 5992 | 5992 | 6200 |
| 8 | 5736 | 5992 | 5992 | 6200 | 6200 | 6456 | 6456 | 6712 | 6968 | 6968 |
| 9 | 6456 | 6712 | 6712 | 6968 | 6968 | 7224 | 7480 | 7480 | 7736 | 7992 |
| 10 | 7224 | 7480 | 7480 | 7736 | 7992 | 7992 | 8248 | 8504 | 8504 | 8760 |
| 11 | 8248 | 8504 | 8760 | 8760 | 9144 | 9144 | 9528 | 9528 | 9912 | 9912 |
| 12 | 9528 | 9528 | 9912 | 9912 | 10296 | 10680 | 10680 | 11064 | 11064 | 11448 |
| 13 | 10680 | 10680 | 11064 | 11448 | 11448 | 11832 | 12216 | 12216 | 12576 | 12960 |
| 14 | 11832 | 12216 | 12216 | 12576 | 12960 | 12960 | 13536 | 13536 | 14112 | 14112 |
| 15 | 12576 | 12960 | 12960 | 13536 | 13536 | 14112 | 14688 | 14688 | 15264 | 15264 |
| 16 | 13536 | 13536 | 14112 | 14112 | 14688 | 14688 | 15264 | 15840 | 15840 | 16416 |
| 17 | 14688 | 15264 | 15264 | 15840 | 16416 | 16416 | 16992 | 17568 | 17568 | 18336 |
| 18 | 16416 | 16416 | 16992 | 17568 | 17568 | 18336 | 18336 | 19080 | 19080 | 19848 |
| 19 | 17568 | 18336 | 18336 | 19080 | 19080 | 19848 | 20616 | 20616 | 21384 | 21384 |
| 20 | 19080 | 19848 | 19848 | 20616 | 20616 | 21384 | 22152 | 22152 | 22920 | 22920 |
| 21 | 20616 | 21384 | 21384 | 22152 | 22920 | 22920 | 23688 | 24496 | 24496 | 25456 |
| 22 | 22152 | 22920 | 22920 | 23688 | 24496 | 24496 | 25456 | 25456 | 26416 | 27376 |
| 23 | 23688 | 24496 | 24496 | 25456 | 25456 | 26416 | 27376 | 27376 | 28336 | 28336 |
| 24 | 25456 | 25456 | 26416 | 26416 | 27376 | 28336 | 28336 | 29296 | 29296 | 30576 |
| 25 | 26416 | 26416 | 27376 | 28336 | 28336 | 29296 | 29296 | 30576 | 31704 | 31704 |

| 26 | 30576 | 30576 | 31704 | 32856 | 32856 | 34008 | 35160 | 35160 | 36696 | 36696 |

Table 1 continued

| $I_{TBS}$ | $N_{PRB}$ | | | | | | | | | |
|---|---|---|---|---|---|---|---|---|---|---|
| | 51 | 52 | 53 | 54 | 55 | 56 | 57 | 58 | 59 | 60 |
| 0 | 1416 | 1416 | 1480 | 1480 | 1544 | 1544 | 1608 | 1608 | 1608 | 1672 |
| 1 | 1864 | 1864 | 1928 | 1992 | 1992 | 2024 | 2088 | 2088 | 2152 | 2152 |
| 2 | 2280 | 2344 | 2344 | 2408 | 2472 | 2536 | 2536 | 2600 | 2664 | 2664 |
| 3 | 2984 | 2984 | 3112 | 3112 | 3240 | 3240 | 3368 | 3368 | 3496 | 3496 |
| 4 | 3624 | 3752 | 3752 | 3880 | 4008 | 4008 | 4136 | 4136 | 4264 | 4264 |
| 5 | 4584 | 4584 | 4776 | 4776 | 4776 | 4968 | 4968 | 5160 | 5160 | 5352 |
| 6 | 5352 | 5352 | 5544 | 5736 | 5736 | 5992 | 5992 | 5992 | 6200 | 6200 |
| 7 | 6200 | 6456 | 6456 | 6712 | 6712 | 6712 | 6968 | 6968 | 7224 | 7224 |
| 8 | 7224 | 7224 | 7480 | 7480 | 7736 | 7736 | 7992 | 7992 | 8248 | 8504 |
| 9 | 7992 | 8248 | 8248 | 8504 | 8760 | 8760 | 9144 | 9144 | 9144 | 9528 |
| 10 | 9144 | 9144 | 9144 | 9528 | 9528 | 9912 | 9912 | 10296 | 10296 | 10680 |
| 11 | 10296 | 10680 | 10680 | 11064 | 11064 | 11448 | 11448 | 11832 | 11832 | 12216 |
| 12 | 11832 | 11832 | 12216 | 12216 | 12576 | 12576 | 12960 | 12960 | 13536 | 13536 |
| 13 | 12960 | 13536 | 13536 | 14112 | 14112 | 14688 | 14688 | 14688 | 15264 | 15264 |
| 14 | 14688 | 14688 | 15264 | 15264 | 15840 | 15840 | 16416 | 16416 | 16992 | 16992 |
| 15 | 15840 | 15840 | 16416 | 16416 | 16992 | 16992 | 17568 | 17568 | 18336 | 18336 |
| 16 | 16416 | 16992 | 16992 | 17568 | 17568 | 18336 | 18336 | 19080 | 19080 | 19848 |
| 17 | 18336 | 19080 | 19080 | 19848 | 19848 | 20616 | 20616 | 20616 | 21384 | 21384 |
| 18 | 19848 | 20616 | 21384 | 21384 | 22152 | 22152 | 22920 | 22920 | 23688 | 23688 |
| 19 | 22152 | 22152 | 22920 | 22920 | 23688 | 24496 | 24496 | 25456 | 25456 | 25456 |
| 20 | 23688 | 24496 | 24496 | 25456 | 25456 | 26416 | 26416 | 27376 | 27376 | 28336 |
| 21 | 25456 | 26416 | 26416 | 27376 | 27376 | 28336 | 28336 | 29296 | 29296 | 30576 |
| 22 | 27376 | 28336 | 28336 | 29296 | 29296 | 30576 | 30576 | 31704 | 31704 | 32856 |
| 23 | 29296 | 29296 | 30576 | 30576 | 31704 | 31704 | 32856 | 32856 | 34008 | 34008 |
| 24 | 31704 | 31704 | 32856 | 32856 | 34008 | 34008 | 35160 | 35160 | 36696 | 36696 |
| 25 | 32856 | 32856 | 34008 | 34008 | 35160 | 35160 | 36696 | 36696 | 37888 | 37888 |

| 26 | 37888 | 37888 | 39232 | 40576 | 40576 | 40576 | 42368 | 42368 | 43816 | 43816 |

Table 1 continued

| $I_{TBS}$ | $N_{PRB}$ | | | | | | | | | |
|---|---|---|---|---|---|---|---|---|---|---|
| | 61 | 62 | 63 | 64 | 65 | 66 | 67 | 68 | 69 | 70 |
| 0 | 1672 | 1736 | 1736 | 1800 | 1800 | 1800 | 1864 | 1864 | 1928 | 1928 |
| 1 | 2216 | 2280 | 2280 | 2344 | 2344 | 2408 | 2472 | 2472 | 2536 | 2536 |
| 2 | 2728 | 2792 | 2856 | 2856 | 2856 | 2984 | 2984 | 3112 | 3112 | 3112 |
| 3 | 3624 | 3624 | 3624 | 3752 | 3752 | 3880 | 3880 | 4008 | 4008 | 4136 |
| 4 | 4392 | 4392 | 4584 | 4584 | 4584 | 4776 | 4776 | 4968 | 4968 | 4968 |
| 5 | 5352 | 5544 | 5544 | 5736 | 5736 | 5736 | 5992 | 5992 | 5992 | 6200 |
| 6 | 6456 | 6456 | 6456 | 6712 | 6712 | 6968 | 6968 | 6968 | 7224 | 7224 |
| 7 | 7480 | 7480 | 7736 | 7736 | 7992 | 7992 | 8248 | 8248 | 8504 | 8504 |
| 8 | 8504 | 8760 | 8760 | 9144 | 9144 | 9144 | 9528 | 9528 | 9528 | 9912 |
| 9 | 9528 | 9912 | 9912 | 10296 | 10296 | 10296 | 10680 | 10680 | 11064 | 11064 |
| 10 | 10680 | 11064 | 11064 | 11448 | 11448 | 11448 | 11832 | 11832 | 12216 | 12216 |
| 11 | 12216 | 12576 | 12576 | 12960 | 12960 | 13536 | 13536 | 13536 | 14112 | 14112 |
| 12 | 14112 | 14112 | 14112 | 14688 | 14688 | 15264 | 15264 | 15264 | 15840 | 15840 |
| 13 | 15840 | 15840 | 16416 | 16416 | 16992 | 16992 | 16992 | 17568 | 17568 | 18336 |
| 14 | 17568 | 17568 | 18336 | 18336 | 18336 | 19080 | 19080 | 19848 | 19848 | 19848 |
| 15 | 18336 | 19080 | 19080 | 19848 | 19848 | 20616 | 20616 | 20616 | 21384 | 21384 |
| 16 | 19848 | 19848 | 20616 | 20616 | 21384 | 21384 | 22152 | 22152 | 22152 | 22920 |
| 17 | 22152 | 22152 | 22920 | 22920 | 23688 | 23688 | 24496 | 24496 | 24496 | 25456 |
| 18 | 24496 | 24496 | 24496 | 25456 | 25456 | 26416 | 26416 | 27376 | 27376 | 27376 |
| 19 | 26416 | 26416 | 27376 | 27376 | 28336 | 28336 | 29296 | 29296 | 29296 | 30576 |
| 20 | 28336 | 29296 | 29296 | 29296 | 30576 | 30576 | 31704 | 31704 | 31704 | 32856 |
| 21 | 30576 | 31704 | 31704 | 31704 | 32856 | 32856 | 34008 | 34008 | 35160 | 35160 |
| 22 | 32856 | 34008 | 34008 | 34008 | 35160 | 35160 | 36696 | 36696 | 36696 | 37888 |
| 23 | 35160 | 35160 | 36696 | 36696 | 37888 | 37888 | 37888 | 39232 | 39232 | 40576 |
| 24 | 36696 | 37888 | 37888 | 39232 | 39232 | 40576 | 40576 | 42368 | 42368 | 42368 |
| 25 | 39232 | 39232 | 40576 | 40576 | 40576 | 42368 | 42368 | 43816 | 43816 | 43816 |

| 26 | 45352 | 45352 | 46888 | 46888 | 48936 | 48936 | 48936 | 51024 | 51024 | 52752 |

Table 1 continued

| $I_{TBS}$ | $N_{PRB}$ | | | | | | | | | |
|---|---|---|---|---|---|---|---|---|---|---|
| | 71 | 72 | 73 | 74 | 75 | 76 | 77 | 78 | 79 | 80 |
| 0 | 1992 | 1992 | 2024 | 2088 | 2088 | 2088 | 2152 | 2152 | 2216 | 2216 |
| 1 | 2600 | 2600 | 2664 | 2728 | 2728 | 2792 | 2792 | 2856 | 2856 | 2856 |
| 2 | 3240 | 3240 | 3240 | 3368 | 3368 | 3368 | 3496 | 3496 | 3496 | 3624 |
| 3 | 4136 | 4264 | 4264 | 4392 | 4392 | 4392 | 4584 | 4584 | 4584 | 4776 |
| 4 | 5160 | 5160 | 5160 | 5352 | 5352 | 5544 | 5544 | 5544 | 5736 | 5736 |
| 5 | 6200 | 6200 | 6456 | 6456 | 6712 | 6712 | 6712 | 6968 | 6968 | 6968 |
| 6 | 7480 | 7480 | 7736 | 7736 | 7736 | 7992 | 7992 | 8248 | 8248 | 8248 |
| 7 | 8760 | 8760 | 8760 | 9144 | 9144 | 9144 | 9528 | 9528 | 9528 | 9912 |
| 8 | 9912 | 9912 | 10296 | 10296 | 10680 | 10680 | 10680 | 11064 | 11064 | 11064 |
| 9 | 11064 | 11448 | 11448 | 11832 | 11832 | 11832 | 12216 | 12216 | 12576 | 12576 |
| 10 | 12576 | 12576 | 12960 | 12960 | 12960 | 13536 | 13536 | 13536 | 14112 | 14112 |
| 11 | 14112 | 14688 | 14688 | 14688 | 15264 | 15264 | 15840 | 15840 | 15840 | 16416 |
| 12 | 16416 | 16416 | 16416 | 16992 | 16992 | 17568 | 17568 | 17568 | 18336 | 18336 |
| 13 | 18336 | 18336 | 19080 | 19080 | 19080 | 19848 | 19848 | 19848 | 20616 | 20616 |
| 14 | 20616 | 20616 | 20616 | 21384 | 21384 | 22152 | 22152 | 22152 | 22920 | 22920 |
| 15 | 22152 | 22152 | 22152 | 22920 | 22920 | 23688 | 23688 | 23688 | 24496 | 24496 |
| 16 | 22920 | 23688 | 23688 | 24496 | 24496 | 24496 | 25456 | 25456 | 25456 | 26416 |
| 17 | 25456 | 26416 | 26416 | 26416 | 27376 | 27376 | 27376 | 28336 | 28336 | 29296 |
| 18 | 28336 | 28336 | 29296 | 29296 | 29296 | 30576 | 30576 | 30576 | 31704 | 31704 |
| 19 | 30576 | 30576 | 31704 | 31704 | 32856 | 32856 | 32856 | 34008 | 34008 | 34008 |
| 20 | 32856 | 34008 | 34008 | 34008 | 35160 | 35160 | 35160 | 36696 | 36696 | 36696 |
| 21 | 35160 | 36696 | 36696 | 36696 | 37888 | 37888 | 39232 | 39232 | 39232 | 40576 |
| 22 | 37888 | 39232 | 39232 | 40576 | 40576 | 40576 | 42368 | 42368 | 42368 | 43816 |
| 23 | 40576 | 40576 | 42368 | 42368 | 43816 | 43816 | 43816 | 45352 | 45352 | 45352 |
| 24 | 43816 | 43816 | 45352 | 45352 | 45352 | 46888 | 46888 | 46888 | 48936 | 48936 |
| 25 | 45352 | 45352 | 46888 | 46888 | 46888 | 48936 | 48936 | 48936 | 51024 | 51024 |

| 26 | 52752 | 52752 | 55056 | 55056 | 55056 | 55056 | 57336 | 57336 | 57336 | 59256 |

Table 1 continued

| $I_{TBS}$ | $N_{PRB}$ | | | | | | | | | |
|---|---|---|---|---|---|---|---|---|---|---|
| | 81 | 82 | 83 | 84 | 85 | 86 | 87 | 88 | 89 | 90 |
| 0 | 2280 | 2280 | 2280 | 2344 | 2344 | 2408 | 2408 | 2472 | 2472 | 2536 |
| 1 | 2984 | 2984 | 2984 | 3112 | 3112 | 3112 | 3240 | 3240 | 3240 | 3240 |
| 2 | 3624 | 3624 | 3752 | 3752 | 3880 | 3880 | 3880 | 4008 | 4008 | 4008 |
| 3 | 4776 | 4776 | 4776 | 4968 | 4968 | 4968 | 5160 | 5160 | 5160 | 5352 |
| 4 | 5736 | 5992 | 5992 | 5992 | 5992 | 6200 | 6200 | 6200 | 6456 | 6456 |
| 5 | 7224 | 7224 | 7224 | 7480 | 7480 | 7480 | 7736 | 7736 | 7736 | 7992 |
| 6 | 8504 | 8504 | 8760 | 8760 | 8760 | 9144 | 9144 | 9144 | 9144 | 9528 |
| 7 | 9912 | 9912 | 10296 | 10296 | 10296 | 10680 | 10680 | 10680 | 11064 | 11064 |
| 8 | 11448 | 11448 | 11448 | 11832 | 11832 | 12216 | 12216 | 12216 | 12576 | 12576 |
| 9 | 12960 | 12960 | 12960 | 13536 | 13536 | 13536 | 13536 | 14112 | 14112 | 14112 |
| 10 | 14112 | 14688 | 14688 | 14688 | 14688 | 15264 | 15264 | 15264 | 15840 | 15840 |
| 11 | 16416 | 16416 | 16992 | 16992 | 16992 | 17568 | 17568 | 17568 | 18336 | 18336 |
| 12 | 18336 | 19080 | 19080 | 19080 | 19080 | 19848 | 19848 | 19848 | 20616 | 20616 |
| 13 | 20616 | 21384 | 21384 | 21384 | 22152 | 22152 | 22152 | 22920 | 22920 | 22920 |
| 14 | 22920 | 23688 | 23688 | 24496 | 24496 | 24496 | 25456 | 25456 | 25456 | 25456 |
| 15 | 24496 | 25456 | 25456 | 25456 | 26416 | 26416 | 26416 | 27376 | 27376 | 27376 |
| 16 | 26416 | 26416 | 27376 | 27376 | 27376 | 28336 | 28336 | 28336 | 29296 | 29296 |
| 17 | 29296 | 29296 | 30576 | 30576 | 30576 | 30576 | 31704 | 31704 | 31704 | 32856 |
| 18 | 31704 | 32856 | 32856 | 32856 | 34008 | 34008 | 34008 | 35160 | 35160 | 35160 |
| 19 | 35160 | 35160 | 35160 | 36696 | 36696 | 36696 | 37888 | 37888 | 37888 | 39232 |
| 20 | 37888 | 37888 | 39232 | 39232 | 39232 | 40576 | 40576 | 40576 | 42368 | 42368 |
| 21 | 40576 | 40576 | 42368 | 42368 | 42368 | 43816 | 43816 | 43816 | 45352 | 45352 |
| 22 | 43816 | 43816 | 45352 | 45352 | 45352 | 46888 | 46888 | 46888 | 48936 | 48936 |
| 23 | 46888 | 46888 | 46888 | 48936 | 48936 | 48936 | 51024 | 51024 | 51024 | 51024 |
| 24 | 48936 | 51024 | 51024 | 51024 | 52752 | 52752 | 52752 | 52752 | 55056 | 55056 |
| 25 | 51024 | 52752 | 52752 | 52752 | 55056 | 55056 | 55056 | 55056 | 57336 | 57336 |

| 26 | 59256 | 59256 | 61664 | 61664 | 61664 | 63776 | 63776 | 63776 | 66592 | 66592 |

Table 1 continued

| $I_{TBS}$ | $N_{PRB}$ | | | | | | | | | |
|---|---|---|---|---|---|---|---|---|---|---|
| | 91 | 92 | 93 | 94 | 95 | 96 | 97 | 98 | 99 | 100 |
| 0 | 2536 | 2536 | 2600 | 2600 | 2664 | 2664 | 2728 | 2728 | 2728 | 2792 |
| 1 | 3368 | 3368 | 3368 | 3496 | 3496 | 3496 | 3496 | 3624 | 3624 | 3624 |
| 2 | 4136 | 4136 | 4136 | 4264 | 4264 | 4264 | 4392 | 4392 | 4392 | 4584 |
| 3 | 5352 | 5352 | 5352 | 5544 | 5544 | 5544 | 5736 | 5736 | 5736 | 5736 |
| 4 | 6456 | 6456 | 6712 | 6712 | 6712 | 6968 | 6968 | 6968 | 6968 | 7224 |
| 5 | 7992 | 7992 | 8248 | 8248 | 8248 | 8504 | 8504 | 8760 | 8760 | 8760 |
| 6 | 9528 | 9528 | 9528 | 9912 | 9912 | 9912 | 10296 | 10296 | 10296 | 10296 |
| 7 | 11064 | 11448 | 11448 | 11448 | 11448 | 11832 | 11832 | 11832 | 12216 | 12216 |
| 8 | 12576 | 12960 | 12960 | 12960 | 13536 | 13536 | 13536 | 13536 | 14112 | 14112 |
| 9 | 14112 | 14688 | 14688 | 14688 | 15264 | 15264 | 15264 | 15264 | 15840 | 15840 |
| 10 | 15840 | 16416 | 16416 | 16416 | 16992 | 16992 | 16992 | 16992 | 17568 | 17568 |
| 11 | 18336 | 18336 | 19080 | 19080 | 19080 | 19080 | 19848 | 19848 | 19848 | 19848 |
| 12 | 20616 | 21384 | 21384 | 21384 | 21384 | 22152 | 22152 | 22152 | 22920 | 22920 |
| 13 | 23688 | 23688 | 23688 | 24496 | 24496 | 24496 | 25456 | 25456 | 25456 | 25456 |
| 14 | 26416 | 26416 | 26416 | 27376 | 27376 | 27376 | 28336 | 28336 | 28336 | 28336 |
| 15 | 28336 | 28336 | 28336 | 29296 | 29296 | 29296 | 29296 | 30576 | 30576 | 30576 |
| 16 | 29296 | 30576 | 30576 | 30576 | 30576 | 31704 | 31704 | 31704 | 31704 | 32856 |
| 17 | 32856 | 32856 | 34008 | 34008 | 34008 | 35160 | 35160 | 35160 | 35160 | 36696 |
| 18 | 36696 | 36696 | 36696 | 37888 | 37888 | 37888 | 37888 | 39232 | 39232 | 39232 |
| 19 | 39232 | 39232 | 40576 | 40576 | 40576 | 40576 | 42368 | 42368 | 42368 | 43816 |
| 20 | 42368 | 42368 | 43816 | 43816 | 43816 | 45352 | 45352 | 45352 | 46888 | 46888 |
| 21 | 45352 | 46888 | 46888 | 46888 | 46888 | 48936 | 48936 | 48936 | 48936 | 51024 |
| 22 | 48936 | 48936 | 51024 | 51024 | 51024 | 51024 | 52752 | 52752 | 52752 | 55056 |
| 23 | 52752 | 52752 | 52752 | 55056 | 55056 | 55056 | 55056 | 57336 | 57336 | 57336 |
| 24 | 55056 | 57336 | 57336 | 57336 | 57336 | 59256 | 59256 | 59256 | 61664 | 61664 |
| 25 | 57336 | 59256 | 59256 | 59256 | 61664 | 61664 | 61664 | 61664 | 63776 | 63776 |

| 26 | 66592 | 68808 | 68808 | 68808 | 71112 | 71112 | 71112 | 73712 | 73712 | 75376 |

Table 1 continued

| $I_{TBS}$ | $N_{PRB}$ | | | | | | | | | |
|---|---|---|---|---|---|---|---|---|---|---|
| | 101 | 102 | 103 | 104 | 105 | 106 | 107 | 108 | 109 | 110 |
| 0 | 2792 | 2856 | 2856 | 2856 | 2984 | 2984 | 2984 | 2984 | 2984 | 3112 |
| 1 | 3752 | 3752 | 3752 | 3752 | 3880 | 3880 | 3880 | 4008 | 4008 | 4008 |
| 2 | 4584 | 4584 | 4584 | 4584 | 4776 | 4776 | 4776 | 4776 | 4968 | 4968 |
| 3 | 5992 | 5992 | 5992 | 5992 | 6200 | 6200 | 6200 | 6200 | 6456 | 6456 |
| 4 | 7224 | 7224 | 7480 | 7480 | 7480 | 7480 | 7736 | 7736 | 7736 | 7992 |
| 5 | 8760 | 9144 | 9144 | 9144 | 9144 | 9528 | 9528 | 9528 | 9528 | 9528 |
| 6 | 10680 | 10680 | 10680 | 10680 | 11064 | 11064 | 11064 | 11448 | 11448 | 11448 |
| 7 | 12216 | 12576 | 12576 | 12576 | 12960 | 12960 | 12960 | 12960 | 13536 | 13536 |
| 8 | 14112 | 14112 | 14688 | 14688 | 14688 | 14688 | 15264 | 15264 | 15264 | 15264 |
| 9 | 15840 | 16416 | 16416 | 16416 | 16416 | 16992 | 16992 | 16992 | 16992 | 17568 |
| 10 | 17568 | 18336 | 18336 | 18336 | 18336 | 18336 | 19080 | 19080 | 19080 | 19080 |
| 11 | 20616 | 20616 | 20616 | 21384 | 21384 | 21384 | 21384 | 22152 | 22152 | 22152 |
| 12 | 22920 | 23688 | 23688 | 23688 | 23688 | 24496 | 24496 | 24496 | 24496 | 25456 |
| 13 | 26416 | 26416 | 26416 | 26416 | 27376 | 27376 | 27376 | 27376 | 28336 | 28336 |
| 14 | 29296 | 29296 | 29296 | 29296 | 30576 | 30576 | 30576 | 30576 | 31704 | 31704 |
| 15 | 30576 | 31704 | 31704 | 31704 | 31704 | 32856 | 32856 | 32856 | 34008 | 34008 |
| 16 | 32856 | 32856 | 34008 | 34008 | 34008 | 34008 | 35160 | 35160 | 35160 | 35160 |
| 17 | 36696 | 36696 | 36696 | 37888 | 37888 | 37888 | 39232 | 39232 | 39232 | 39232 |
| 18 | 40576 | 40576 | 40576 | 40576 | 42368 | 42368 | 42368 | 42368 | 43816 | 43816 |
| 19 | 43816 | 43816 | 43816 | 45352 | 45352 | 45352 | 46888 | 46888 | 46888 | 46888 |
| 20 | 46888 | 46888 | 48936 | 48936 | 48936 | 48936 | 48936 | 51024 | 51024 | 51024 |
| 21 | 51024 | 51024 | 51024 | 52752 | 52752 | 52752 | 52752 | 55056 | 55056 | 55056 |
| 22 | 55056 | 55056 | 55056 | 57336 | 57336 | 57336 | 57336 | 59256 | 59256 | 59256 |
| 23 | 57336 | 59256 | 59256 | 59256 | 59256 | 61664 | 61664 | 61664 | 61664 | 63776 |
| 24 | 61664 | 61664 | 63776 | 63776 | 63776 | 63776 | 66592 | 66592 | 66592 | 66592 |
| 25 | 63776 | 63776 | 66592 | 66592 | 66592 | 66592 | 68808 | 68808 | 68808 | 71112 |

| 26 | 75376 | 75376 | 75376 | 75376 | 75376 | 75376 | 75376 | 75376 | 75376 | 75376 |
|----|-------|-------|-------|-------|-------|-------|-------|-------|-------|-------|

Table 2: Correspondence table of a modulation and coding scheme, a modulation scheme, and a TBS index value in a PDSCH

| MCS Index $I_{mcs}$ | Modulation Order $Q_m$ | TBS Index $I_{TBS}$ |
|---|---|---|
| 0 | 2 | 0 |
| 1 | 2 | 1 |
| 2 | 2 | 2 |
| 3 | 2 | 3 |
| 4 | 2 | 4 |
| 5 | 2 | 5 |
| 6 | 2 | 6 |
| 7 | 2 | 7 |
| 8 | 2 | 8 |
| 9 | 2 | 9 |
| 10 | 4 | 9 |
| 11 | 4 | 10 |
| 12 | 4 | 11 |
| 13 | 4 | 12 |
| 14 | 4 | 13 |
| 15 | 4 | 14 |
| 16 | 4 | 15 |
| 17 | 6 | 15 |
| 18 | 6 | 16 |
| 19 | 6 | 17 |
| 20 | 6 | 18 |
| 21 | 6 | 19 |
| 22 | 6 | 20 |
| 23 | 6 | 21 |
| 24 | 6 | 22 |
| 25 | 6 | 23 |
| 26 | 6 | 24 |
| 27 | 6 | 25 |
| 28 | 6 | 26 |
| 29 | 2 | Reserved |
| 30 | 4 | Reserved |
| 31 | 6 | Reserved |

310

320

330

340

| First determining module | Outer-code coding module | Second determining module | Inner-code coding module |

FIG. 3

Processor — 420

Bus — 460

Read-only memory

Basic input and output system

— 440

Random access memory

Operating system

— 450

Application program

Transmitter — 430

Receiver — 410

FIG. 4

<div align="center">

**INTERNATIONAL SEARCH REPORT**

</div>

| International application No. |
| --- |
| **PCT/CN2015/078544** |

**A. CLASSIFICATION OF SUBJECT MATTER**

H03M 13/29 (2006.01) i; H04L 1/00 (2006.01) i

According to International Patent Classification (IPC) or to both national classification and IPC

**B. FIELDS SEARCHED**

Minimum documentation searched (classification system followed by classification symbols)

H04L; H03M

Documentation searched other than minimum documentation to the extent that such documents are included in the fields searched

Electronic data base consulted during the international search (name of data base and, where practicable, search terms used)

CNKI, CNPAT, WPI, EPODOC: RS code, inner code, outer code, coding, modulation, coding efficiency, bit error, bit, reed-solomon code

**C. DOCUMENTS CONSIDERED TO BE RELEVANT**

| Category* | Citation of document, with indication, where appropriate, of the relevant passages | Relevant to claim No. |
| --- | --- | --- |
| X | CN 101013931 A (BEIJING INNOFIDEI TECHNOLOGY CO., LTD.), 08 August 2007 (08.08.2007), description, page 5, paragraph 4 to page 6, paragraph 5 and page 7, line 1 to page 10, line 6 | 1-15 |
| A | CN 104518844 A (HUAWEI TECHNOLOGIES CO., LTD.), 15 April 2015 (15.04.2015), the whole document | 1-15 |
| A | CN 1929614 A (UNIVERSITY OF ELECTRONIC SCIENCE AND TECHNOLOGY OF CHINA), 14 March 2007 (14.03.2007), the whole document | 1-15 |
| A | CN 1768482 A (PANASONIC CORPORATION), 03 May 2006 (03.05.2006), the whole document | 1-15 |

☐ Further documents are listed in the continuation of Box C.     ☒ See patent family annex.

| *   Special categories of cited documents: | "T"   later document published after the international filing date or priority date and not in conflict with the application but cited to understand the principle or theory underlying the invention |
| --- | --- |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
| --- | --- |
| 29 January 2016 (29.01.2016) | **06 February 2016 (06.02.2016)** |

| Name and mailing address of the ISA/CN: <br> State Intellectual Property Office of the P. R. China <br> No. 6, Xitucheng Road, Jimenqiao <br> Haidian District, Beijing 100088, China <br> Facsimile No.: (86-10) 62019451 | Authorized officer <br><br> **ZHANG, Qi** <br><br> Telephone No.: (86-10) **62413261** |

Form PCT/ISA/210 (second sheet) (July 2009)

## INTERNATIONAL SEARCH REPORT
Information on patent family members

International application No.

**PCT/CN2015/078544**

| Patent Documents referred in the Report | Publication Date | Patent Family | Publication Date |
|---|---|---|---|
| CN 101013931 A | 08 August 2007 | None | |
| CN 104518844 A | 15 April 2015 | None | |
| CN 1929614 A | 14 March 2007 | None | |
| CN 1768482 A | 03 May 2006 | JP 2004304268 A | 28 October 2004 |
| | | WO 2004088853 A1 | 14 October 2004 |
| | | US 2006195756 A1 | 31 August 2006 |
| | | EP 1605598 A1 | 14 December 2005 |

Form PCT/ISA/210 (patent family annex) (July 2009)